# EUROPEAN PATENT APPLICATION

(11) **EP 3 316 327 A1**
(43) Date of publication of application: **02.05.2018**
(21) Application number: 16814349.3
(22) Date of filing: 21.06.2016
(51) Int. Cl.: H01L 51/46

(54) **PHOTOELECTRIC CONVERSION ELEMENT, SOLAR BATTERY, METAL SALT COMPOSITION, AND MANUFACTURING METHOD FOR PHOTOELECTRIC CONVERSION ELEMENT**

(30) Priority: 26.06.2015 JP 2015128511
(71) Applicant: FUJI-FILM Corporation, Minato-ku Tokyo 106-8620 (JP)
(72) Inventor: SATOU, Hirotaka, Ashigarakami-gun Kanagawa 258-8577 (JP); HANAKI, Naoyuki, Ashigarakami-gun Kanagawa 258-8577 (JP); ISE, Toshihiro, Ashigarakami-gun Kanagawa 258-8577 (JP)
(74) Representative: Hoffmann Eitle
(86) International application number: PCT/JP2016/068386
(87) International publication number: WO 2016/208579

(57) **Abstract**

Provided is a photoelectric conversion element including: a first electrode that includes a photosensitive layer containing a perovskite-type light absorbing agent on a conductive support; and a second electrode that is opposite to the first electrode. The perovskite-type light absorbing agent includes a metal cation M1 as a central ion of a perovskite-type crystal structure thereof, and a metal cation M2, of which a valence is different from a valence of the metal cation M1, of a metal atom other than elements of Group 1 in the periodic table. In addition, there are provided a solar cell, a method of manufacturing the photoelectric conversion element, and a metal salt composition.

## Description

### BACKGROUND OF THE INVENTION

### 1. Field of the Invention

The present invention relates a photoelectric conversion element, a solar cell, a metal salt composition, and a method of manufacturing a photoelectric conversion element.

### 2. Description of the Related Art

Photoelectric conversion elements are used in a variety of optical sensors, copiers, solar cells, and the like. It is expected that solar cells will be actively put into practical use as cells using non-exhaustible solar energy. Among these, research and development of dye sensitized solar cells, in which an organic dye, a Ru bipyridyl complex, or the like is used as a sensitizer, are actively in progress, and the photoelectric conversion efficiency thereof reaches approximately 11%.

Meanwhile, in recent years, there have been reported research results indicating that solar cells using a metal halide having a perovskite-type crystal structure as a light absorbing agent are capable of achieving relatively high photoelectric conversion efficiency, and the solar cells attract attention (for example, Science, 2012, vol. 338, p. 643 to 647). In Science, 2012, vol. 338, p. 643 to 647, a solar cell that uses a metal halide represented by CH₃NH₃PbI₂Cl as the light absorbing agent is described.

### SUMMARY OF THE INVENTION

In photoelectric conversion elements using a compound (hereinafter, referred to as "perovskite compound) having the perovskite-type crystal structure as the light absorbing agent, a constant improvement in photoelectric conversion efficiency is attained. However, the photoelectric conversion elements using the perovskite compound as the light absorbing agent recently attract attention, and is demanded to attain an additional improvement in the photoelectric conversion efficiency. Accordingly, an improvement in an increase of a short-circuit current (simply referred to as "current"), and an improvement in an open-circuit voltage have become important.

In addition, in practical use of the photoelectric conversion elements, it is further demanded to reduce a variation in a performance between elements which are manufactured in addition to the improvement in the photoelectric conversion efficiency. However, in the photoelectric conversion element using the perovskite compound as the light absorbing agent, initial photoelectric conversion efficiency (during manufacturing) is likely to vary, and the variation is not sufficiently reduced yet.

An object of the invention is to provide a photoelectric conversion element which uses a perovskite compound as a light absorbing agent, in which a current value is high, and which is capable of reducing a variation in photoelectric conversion efficiency between elements, and a solar cell. In addition, another object of the invention is to provide a method of manufacturing a photoelectric conversion element having an excellent performance, and a metal salt composition that is used therein.

The present inventors have obtained the following finding. In the photoelectric conversion element or the solar cell that uses the perovskite compound as the light absorbing agent, in addition to a central ion of a perovskite-type crystal, when a specific metal cation having a valence different from that of the metal cation as a central ion is contained in the perovskite compound, a photoelectric conversion element or a solar cell, in which a high current value is exhibited and a variation in photoelectric conversion efficiency is suppressed, is obtained. The invention has been accomplished by additionally repeating examinations on the basis of the finding.

That is, the above-described objects are accomplished by the following means.
<1> According to an aspect of the invention, there is provided a photoelectric conversion element comprising: a first electrode that includes a photosensitive layer containing a perovskite-type light absorbing agent on a conductive support; and a second electrode that is opposite to the first electrode.
   The perovskite-type light absorbing agent includes a metal cation M1 as a central ion of a perovskite-type crystal structure of the perovskite-type light absorbing agent, and a metal cation M2, of which a valence is different from a valence of the metal cation M1, of a metal atom other than elements of Group 1 in the periodic table.
<2> In the photoelectric conversion element according to <1>, the perovskite-type light absorbing agent may be formed by bringing a metal salt MS1 in which the metal cation M1 is set as a cation, a metal salt MS2 in which the metal cation M2 is set as a cation, and a salt AX in which a cation other than the central ion of the perovskite-type crystal structure is set as a cation into contact with each other on a surface on which the photosensitive layer is formed.
<3> In the photoelectric conversion element according to <1> or <2>, a valence of the metal cation M2 may be greater than a valence of the metal cation M1, and the amount of the metal cation M2 may be smaller than the amount of the metal cation M1.
<4> In the photoelectric conversion element according to any one of <1> to <3>, a ratio of the amount of the metal cation M1 contained to the amount of the metal cation M2 contained may be 19 to 499 in terms of a molar ratio.
<5> In the photoelectric conversion element according to any one of <1> to <4>, a ratio of the amount of the metal cation M1 contained to the amount of the metal cation M2 contained may be 49 to 199 in terms of a molar ratio.
<6> In the photoelectric conversion element according to any one of <1> to <5>, the metal cation M1 may be at least one kind selected from the group consisting of a divalent lead cation and a divalent tin cation.
<7> In the photoelectric conversion element according to any one of <1> to <6>, the metal cation M2 may be at least one kind selected from the group consisting of a tetravalent lead cation and a tetravalent tin cation.
<8> In the photoelectric conversion element according to any one of <1> to <7>, the metal cation M1 may be a divalent lead cation, and the metal cation M2 may be a tetravalent tin cation.
<9> In the photoelectric conversion element according to any one of <1> to <8>, the perovskite-type light absorbing agent may include a compound having a perovskite-type crystal structure that includes a cation of elements of Group 1 in the periodic table or a cationic organic group A, a metal cation of the metal atom M1 other than elements of Group 1 in the periodic table, and an anion of an anionic atom or atomic group X.
<10> The photoelectric conversion element according to any one of <1> to <9> may further comprise a hole transport layer that is provided between the first electrode and the second electrode.
<11> The photoelectric conversion element according to any one of <1> to <10> may further comprise a porous layer that is provided between the conductive support and the photosensitive layer.
<12> According to another aspect of the invention, there is provided a solar cell that uses the photoelectric conversion element according to any one of <1> to <11>.
<13> According to still another aspect of the invention, there is provided a metal salt composition that is used to form a perovskite-type light absorbing agent that includes a metal cation M1 as a central ion of a perovskite-type crystal structure, and a metal cation M2, of which a valence is different from a valence of the metal cation M 1, of a metal atom other than elements of Group 1 in the periodic table.
   The metal salt composition contains a metal salt MS1 in which the metal cation M1 is set as a cation, a metal salt MS2 in which the metal cation M2 is set as a cation, and an organic solvent.
<14> In the metal salt composition according to <13>, the metal salts MS1 and MS2 may include a halide ion or a monovalent organic anion as an anion.
<15> According to still another aspect of the invention, there is provided a method of manufacturing the photoelectric conversion element according to any one of <1> to <11>.
   The method comprises bringing a metal salt MS1 in which a metal cation M1 as a central ion of a perovskite-type crystal structure is set as a cation, a metal salt MS2 in which a metal cation M2, of which a valence is different from a valence of the metal cation M1, of a metal atom other than elements of Group 1 in the periodic table is set as a cation, and a salt AX in which a cation other than the central ion of the perovskite-type crystal structure is set as a cation into contact with each other on a surface of a layer on which a photosensitive layer is to be formed so as to form a perovskite-type light absorbing agent on the surface.
<16> In the method of manufacturing the photoelectric conversion element according to <15>, a metal salt composition, which contains the metal salt MS1, the metal salt MS2, and an organic solvent, may be brought into contact with the surface, and the salt AX may be subsequently brought into contact with the surface.

In this specification, parts of respective formulae may be expressed as a rational formula for understanding of chemical structures of compounds. According to this, in the respective formulae, partial structures are called (substituent) groups, ions, atoms, and the like, but in this specification, the partial structures may represent element groups or elements which constitute (substituent) groups or ions represented by the formulae in addition to the (substituent) groups, the ions, the atoms, and the like.

In this specification, with regard to expression of compounds (including a complex and a dye), the expression is also used to indicate salts of the compounds and ions of the compounds in addition to the compounds. In addition, with regard to compounds for which substitution or non-substitution is not specified, the compounds also include compounds which have an arbitrary substituent group in a range not deteriorating a target effect. This is also true of substituent groups, linking groups, and the like (hereinafter, referred to as "substituent group and the like").

In this specification, in a case where a plurality of substituent groups and the like expressed using specific symbols or a plurality of substituent groups and the like are simultaneously defined, the respective substituent groups and the like may be identical to or different from each other unless otherwise stated. This is also true of definition of the number of substituent groups and the like. In addition, in a case of approaching to each other (particularly, in a case of being close to each other), the plurality of substituent groups and the like may be coupled to each other to form a ring unless otherwise stated. In addition, rings, for example, alicycles, aromatic rings, and hetero rings may be additionally fused together to form a fused ring.

In this specification, numerical ranges represented by using "to" include ranges including numerical values before and after "to" as the lower limit and the upper limit.

Even though the photoelectric conversion element and the solar cell of the invention use the perovskite compound as a light absorbing agent, a current value is high, and a variation in photoelectric conversion efficiency between elements is reduced. In addition, even though the method of manufacturing a photoelectric conversion element uses the perovskite compound as the light absorbing agent, it is possible to manufacture a photoelectric conversion element or a solar cell in which the current value is high and the variation in the photoelectric conversion efficiency between elements is small. In addition, the metal salt composition of the invention can synthesize the perovskite compound that is used as the light absorbing agent in the photoelectric conversion element or the solar cell which exhibits excellent characteristics.

The above-described and other characteristics and advantages of the invention will be further clarified from the following description with appropriate reference to the accompanying drawings.

### BRIEF DESCRIPTION OF THE DRAWINGS

Fig. 1 is a cross-sectional view schematically illustrating a preferred aspect of a photoelectric conversion element of the invention in addition to an enlarged view of a circle portion in a layer.
Fig. 2 is a cross-sectional view schematically illustrating a preferred aspect of the photoelectric conversion element of the invention in which a thick film-shaped photosensitive layer is provided.
Fig. 3 is a cross-sectional view schematically illustrating another preferred aspect of the photoelectric conversion element of the invention.
Fig. 4 is a cross-sectional view schematically illustrating still another preferred aspect of the photoelectric conversion element of the invention.
Fig. 5 is a cross-sectional view schematically illustrating still another preferred aspect of the photoelectric conversion element of the invention.
Fig. 6 is a cross-sectional view schematically illustrating still another preferred aspect of the photoelectric conversion element of the invention.

### DESCRIPTION OF THE PREFERRED EMBODIMENTS

### <<Photoelectric Conversion Element>>

A photoelectric conversion element of the invention includes a first electrode provided with a photosensitive layer, which contains a perovskite compound (also referred to as "perovskite-type light absorbing agent) used as a light absorbing agent, on a conductive support, and a second electrode that is opposite to the first electrode.

In the invention, the aspect in which the photosensitive layer is provided on the conductive support includes an aspect in which the photosensitive layer is (directly) provided to be in contact with a surface of the conductive support, and an aspect in which the photosensitive layer is provided on an upper side of the surface of the conductive support through another layer.

In the aspect in which the photosensitive layer is provided on the upper side of the surface of the conductive support through another layer, as the other layer that is provided between the conductive support and the photosensitive layer, there is no particular limitation as long as the other layer does not deteriorate a battery performance of a solar cell. Examples of the other layer include a porous layer, a blocking layer, an electron transport layer, a hole transport layer, and the like.

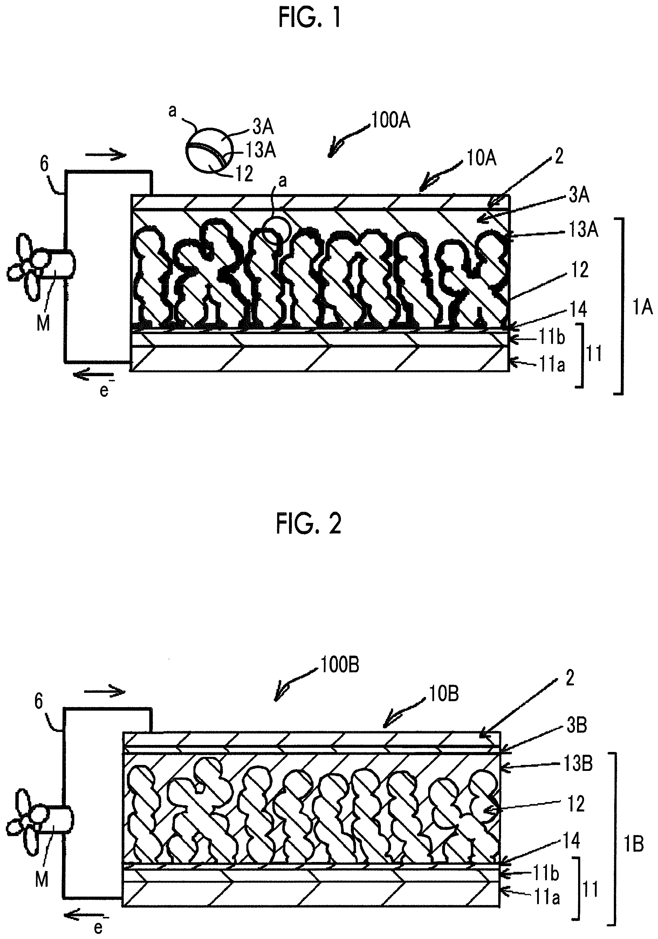

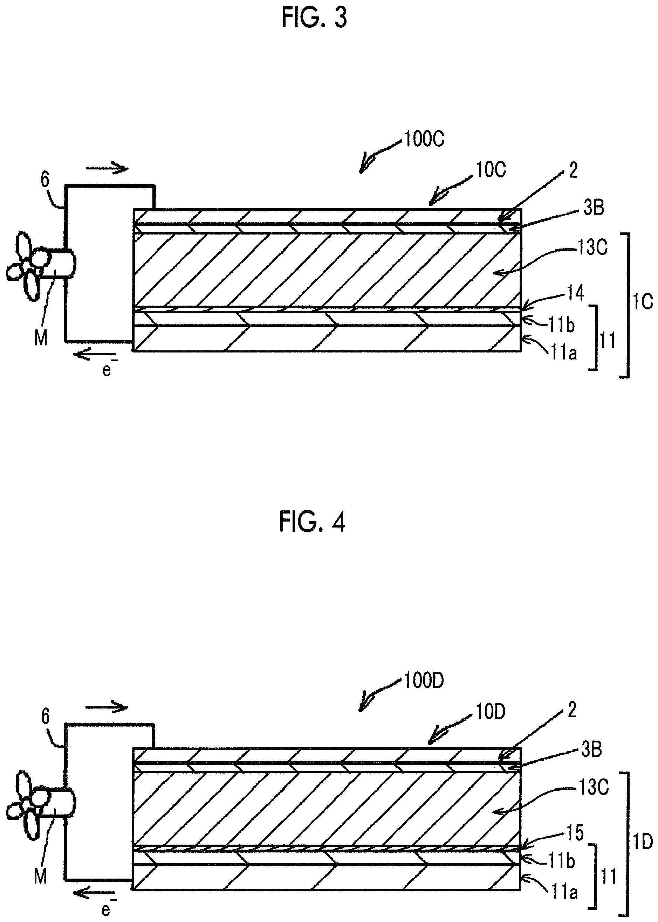

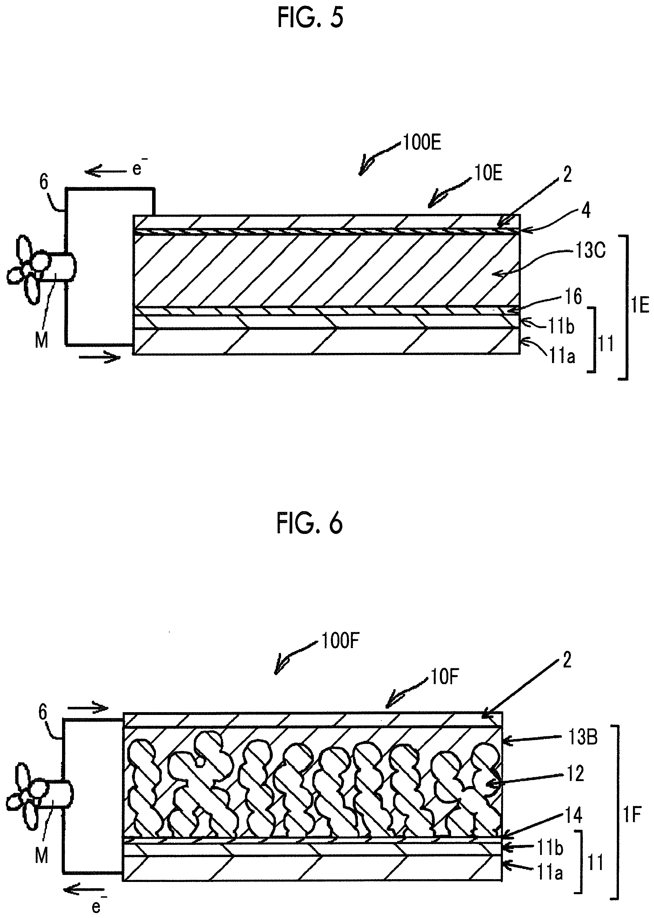

In the invention, examples of the aspect in which the photosensitive layer is provided on an upper side of the surface of the conductive support through another layer include an aspect in which the photosensitive layer is provided on a surface of a porous layer in a thin film shape and the like (refer to Fig. 1), an aspect in which the photosensitive layer is provided on the surface of the porous layer in a thick film shape (refer to Fig. 2 and Fig. 6), an aspect in which the photosensitive layer is provided on a surface of a blocking layer in a thin film shape and an aspect in which the photosensitive layer is provided on the surface of the blocking layer in a thick film shape (refer to Fig. 3), an aspect in which the photosensitive layer is formed on a surface of an electron transport layer in a thin film shape or a thick film shape (refer to Fig. 4), an aspect in which the photosensitive layer is provided, and an aspect in which the photosensitive layer is provided on a surface of a hole transport layer in a thin film shape or thick film shape (refer to Fig. 5). The photosensitive layer may be provided in a linear shape or in a dispersed pattern, but is preferably provided in a film shape.

In the photoelectric conversion element of the invention, the perovskite-type light absorbing agent includes a metal cation M1 as a central ion of a perovskite-type crystal structure, and a metal cation M2 of a metal atom of which a valence is different from a valence of the metal cation M1. The metal cation M2 is a cation of a metal atom other than elements of Group 1 in the periodic table.

In the invention, the central ion of the perovskite-type crystal structure represents a cation M1 that becomes a central ion of an octahedral structure of (M1)X₆, for example, when expressing the perovskite compound with the following Formula (I): Aₐ(M1)ₘXₓ.

A valence of the metal cation represents an ionic valence.

In the invention, "the perovskite-type light absorbing agent includes the metal cation M2" represents that the metal cation M2 is contained on a surface or on an inner side of the perovskite-type light absorbing agent. Accordingly, in a case where the photosensitive layer is formed with the perovskite-type light absorbing agent, it can be said that the metal cation M2 is included in the photosensitive layer.

In the invention, the metal cation M2 represents a cationic metal atom or a metal atomic group that can become a metal cation through charge separation with respect to a counter anion. For example, the metal cation M2 includes a cationic metal atom or a metal atomic group that is included in a compound that generates a charge-separated cation and a metal cation, for example, a complex or a metal salt in which complete charge separation does not occur with respect to a counter anion. The compound is not particularly limited, and examples thereof include an oxide, a halide, a hydroxide, a sulfide, a cyanide, an organic acid salt or an inorganic acid salt (acetate, oxo acid salt, sulfate, carbonate, and the like), a hydrogen compound, a metal complex, and the like of the metal cation M2.

Accordingly, as described above, the metal cation M2 may be included in the perovskite-type light absorbing agent as a cation or as a compound such as a metal salt.

The metal cation M2 may be included in the perovskite-type light absorbing agent and the like in an arbitrary aspect. Examples of the aspect include an aspect in which the metal cation M2 is drawn to the inside or a surface of the perovskite-type crystal structure, an aspect in which the metal cation M2 exists outside the perovskite-type crystal structure, and the like. More specific examples of the aspect in which the metal cation M2 is drawn to the inside or the surface of the perovskite-type crystal structure include intrusion into the perovskite-type crystal structure, substitution of a cation that forms the perovskite-type crystal structure, interlayer intrusion (for example, intercalation) of a perovskite-type light absorbing agent, and the like. In addition, more specific examples of the aspect in which the metal cation M2 exists outside the perovskite-type crystal structure include an aspect in which the metal cation M2 exists between perovskite crystal structures which are not continuous, or on a surface of a photosensitive layer, and the like.

In the invention, if the perovskite-type light absorbing agent includes the metal cation M2, a current value increases. This is assumed to be because the metal cation M2 generates a carrier (in-charge of charge transport) and thus electron conduction (charge migration) in the perovskite-type light absorbing agent becomes smooth. This effect of improving the charge migration is intensified when the amount of the metal cation M2 with respect to the amount of the metal cation M1 is in a range to be described later.

In addition, the perovskite-type light absorbing agent, which includes the metal cation M2, can form a uniform photosensitive layer, preferably, with a small interface defect, and thus it is assumed that the current value increases. Particularly, wettability of a material, which includes metal salts of the metal cation M2 and the metal cation M1, is improved, and thus it is possible to form a uniform photosensitive layer in which an application defect is less.

In addition, if the perovskite-type light absorbing agent includes the metal cation M2, a variation in photoelectric conversion efficiency between elements is reduced in addition to the current value improving effect. The reason for the variation reduction effect is assumed as follows. The perovskite-type light absorbing agent, which includes the metal cation M2, can form a uniform photosensitive layer, which is less in the application defect or the interface defect (these may be collectively referred to as "film surface defect"), with reproducibility.

In the invention, whether or not the perovskite-type light absorbing agent includes the metal cation M2 can be confirmed through analysis of the perovskite-type light absorbing agent, typically, a photosensitive layer 13 by an analysis method in combination of X-ray absorption fine structure analysis (XAFS) and inductively coupled plasma spectrometry (ICP).

Conditions in the analysis method are not particularly limited. For example, first, element species of metal cations included in the perovskite-type light absorbing agent and composition ratios thereof are identified by the ICP. Subsequently, the XAFS analysis is performed with respect to respective elements to measure signal intensities of peaks respectively corresponding to the metal cation M1 and the metal cation M2. These values are plotted with respect to a calibration curve which is created in advance by using the metal cation M1 alone, the metal cation M2 alone, and a sample obtained by mixing the metal cation M1 and the metal cation M2 in a specific ratio and in which the horizontal axis represents a molar ratio ([M1]/[M2]) and the vertical axis represents the signal intensity of an M1 material, thereby obtaining a molar ratio ([M1]/[M2]) of the amounts of the metal cations.

In the photoelectric conversion element of the invention, a configuration other than a configuration defined in the invention is not particularly limited, and it is possible to employ a configuration that is known with respect to the photoelectric conversion element and the solar cell. Respective layers, which constitute the photoelectric conversion element of the invention, are designed in correspondence with the purposes thereof, and may be formed, for example, in a monolayer or multilayers. For example, a porous layer may be provided between a conductive support and a photosensitive layer (refer to Fig. 1, Fig. 2, and Fig. 6).

Hereinafter, description will be given of preferred aspects of the photoelectric conversion element of the invention.

In Fig. 1 to Fig. 6, the same reference numeral represents the same constituent element (member).

Furthermore, in Fig. 1, Fig. 2, and Fig. 6, the size of fine particles which form a porous layer 12 is illustrated in a highlighted manner. These fine particles are preferably packed with each other (are vapor-deposited or in close contact with each other) in the horizontal direction and the vertical direction with respect to a conductive support 11 to form a porous structure.

In this specification, simple description of "photoelectric conversion element 10" represents photoelectric conversion elements 10A to 10F unless otherwise stated. This is also true of a system 100 and a first electrode 1. In addition, simple description of "photosensitive layer 13" represents photosensitive layers 13A to 13C unless otherwise stated. Similarly, description of "hole transport layer 3" represents hole transport layers 3A and 3B unless otherwise stated.

Examples of a preferred aspect of the photoelectric conversion element of the invention include the photoelectric conversion element 10A illustrated in Fig. 1. A system 100A illustrated in Fig. 1 is a system in which the photoelectric conversion element 10A is applied to a cell that allows operation means M (for example, an electric motor) to operate with an external circuit 6.

The photoelectric conversion element 10A includes a first electrode 1A, a second electrode 2, and the hole transport layer 3A that is provided between the first electrode 1A and the second electrode 2.

The first electrode 1A includes the conductive support 11 including a support 11a and a transparent electrode 11b, the porous layer 12, and a photosensitive layer 13A that is provided with a perovskite-type light absorbing agent on a surface of the porous layer 12 as schematically illustrated in an enlarged cross-sectional region "a" obtained by enlarging the cross-sectional area "a" in Fig. 1. In addition, a blocking layer 14 is provided on the transparent electrode 11b, and the porous layer 12 is formed on the blocking layer 14. As described above, in the photoelectric conversion element 10A including the porous layer 12, it is assumed that a surface area of the photosensitive layer 13A increases, and thus charge separation and charge migration efficiency are improved.

The photoelectric conversion element 10B illustrated in Fig. 2 schematically illustrates a preferred aspect in which the photosensitive layer 13A of the photoelectric conversion element 10A illustrated in Fig. 1 is provided to be thick. In the photoelectric conversion element 10B, the hole transport layer 3B is provided to be thin. The photoelectric conversion element 10B is different from the photoelectric conversion element 10A illustrated in Fig. 1 in the film thickness of the photosensitive layer 13B and the hole transport layer 3B, but the photoelectric conversion element 10B has the same configuration as that of the photoelectric conversion element 10A except for the difference.

The photoelectric conversion element 10C illustrated in Fig. 3 schematically illustrates another preferred aspect of the photoelectric conversion element of the invention. The photoelectric conversion element 10C is different from the photoelectric conversion element 10B illustrated in Fig. 2 in that the porous layer 12 is not provided, but the photoelectric conversion element 10C has the same configuration as that of the photoelectric conversion element 10B except for the difference. That is, in the photoelectric conversion element 10C, the photosensitive layer 13C is formed on the surface of the blocking layer 14 in a thick film shape. In the photoelectric conversion element 10C, the hole transport layer 3B may be provided to be thick in the same manner as in the hole transport layer 3A.

The photoelectric conversion element 10D illustrated in Fig. 4 schematically illustrates still another preferred aspect of the photoelectric conversion element of the invention. The photoelectric conversion element 10D is different from the photoelectric conversion element 10C illustrated in Fig. 3 in that an electron transport layer 15 is provided instead of the blocking layer 14, but the photoelectric conversion element 10D has the same configuration as that of the photoelectric conversion element 10C except for the difference. The first electrode 1D includes the conductive support 11, and the electron transport layer 15 and the photosensitive layer 13C which are sequentially formed on the conductive support 11. The photoelectric conversion element 10D is preferable when considering that the respective layers can be formed from an organic material. According to this, the productivity of the photoelectric conversion element is improved, and thickness reduction or flexibilization becomes possible.

The photoelectric conversion element 10E illustrated in Fig. 5 schematically illustrates still another preferred aspect of the photoelectric conversion element of the invention. A system 100E including the photoelectric conversion element 10E is a system that is applied as a cell in the same manner as in the system 100A.

The photoelectric conversion element 10E includes a first electrode 1E, the second electrode 2, and the electron transport layer 4 that is provided between the first electrode 1E and the second electrode 2. The first electrode 1E includes the conductive support 11, and the hole transport layer 16 and the photosensitive layer 13C which are sequentially formed on the conductive support 11. The photoelectric conversion element 10E is preferable when considering that the respective layers can be formed from an organic material in the same manner as in the photoelectric conversion element 10D.

The photoelectric conversion element 10F illustrated in Fig. 6 schematically illustrates still another preferred aspect of the photoelectric conversion element of the invention. The photoelectric conversion element 10F is different from the photoelectric conversion element 10B illustrated in Fig. 2 in that the hole transport layer 3B is not provided, but the photoelectric conversion element 10F has the same configuration as that of the photoelectric conversion element 10B except for the difference.

In the invention, a system 100 to which the photoelectric conversion element 10 is applied functions as a solar cell in the following manner.

Specifically, in the photoelectric conversion element 10, light that is transmitted through the conductive support 11, or light that is transmitted through the second electrode 2 and is incident to the photosensitive layer 13 excites a light absorbing agent. The excited light absorbing agent includes high-energy electrons and can emit the electrons. The light absorbing agent, which emits high-energy electrons, becomes an oxidized substance (cation).

In the photoelectric conversion elements 10A to 10D, and 10F, electrons emitted from the light absorbing agent migrate between a plurality of the light absorbing agents and reach the conductive support 11. The electrons which have reached the conductive support 11 do work in the external circuit 6, and then return to the photosensitive layer 13 through the second electrode 2 (in a case where the hole transport layer 3 is provided, additionally through the hole transport layer 3). The light absorbing agent is reduced by the electrons which have returned to the photosensitive layer 13.

On the other hand, in the photoelectric conversion element 10E, the electrons, which are emitted from the light absorbing agent, reach the second electrode 2 from the photosensitive layer 13C through the electron transport layer 4, and do work in the external circuit 6. Then, the electrons return to the photosensitive layer 13 through the conductive support 11. The light absorbing agent is reduced by the electrons which have returned to the photosensitive layer 13.

In the photoelectric conversion element 10, a cycle of excitation of the light absorbing agent and electron migration is repeated, and thus the system 100 functions as a solar cell. In the photoelectric conversion element of the invention, the perovskite-type light absorbing agent contains the metal cation M2. Accordingly, as to be described later, a current value of the photoelectric conversion element 10 (system 100) is improved due to smoothness of electron conduction and the like.

In the photoelectric conversion elements 10A to 10D, and 10F, a method of allowing an electron to flow from the photosensitive layer 13 to the conductive support 11 is different depending on presence or absence of the porous layer 12, a kind thereof, and the like. In the photoelectric conversion element 10 of the invention, electron conduction, in which electrons migrate between the light absorbing agents, occurs. In the invention, in a case where the porous layer 12 is provided, the porous layer 12 can be formed from an insulating substance other than semiconductors in the related art. In a case where the porous layer 12 is formed from a semiconductor, electron conduction, in which electrons migrate at the inside of semiconductor fine particles of the porous layer 12 or between the semiconductor fine particles, also occurs. On the other hand, in a case where the porous layer 12 is formed from an insulating substance, electron conduction in the porous layer 12 does not occur. In a case where the porous layer 12 is formed from the insulating substance, when using an aluminum oxide (Al₂O₃) as the fine particles of the insulating substance, a relatively high electromotive force (V_{OC}) is obtained.

Even in a case where the blocking layer 14 as the other layer is formed from a conductor or a semiconductor, electron conduction in the blocking layer 14 occurs.

In addition, even in the electron transport layer 15, electron conductor occurs.

The photoelectric conversion element and the solar cell of the invention are not limited to the preferred aspects, and configurations and the like of the respective aspects may be appropriately combined between the respective aspects in a range not departing from the gist of the invention. For example, the photoelectric conversion element 10C or 10D may have a configuration in which the hole transport layer 3B is not provided in the same manner as in the photoelectric conversion element 10F.

In the invention, materials and respective members which are used in the photoelectric conversion element and the solar cell can be prepared by using a typical method except for the light absorbing agent. With regard to a photoelectric conversion element or a solar cell in which a perovskite compound is used, for example, reference can be made to Science, 2012, vol. 338, p. 643 to 647 and J. Am. Chem. Soc., 2009, 131(17), p. 6050-6051.

In addition, reference can be made to materials and respective members which are used in a dye sensitized solar cell. With regard to dye sensitized solar cells, for example, reference can be made to JP2001-291534A, US4,927,721A, US4,684,537A, US5,084,365A, US5,350,644A, US5,463,057A, US5,525,440A, JP1995-249790A (JP-H7-249790A), JP2004-220974A, and JP2008-135197A.

Hereinafter, description will be given of members and compounds which are appropriately used in the photoelectric conversion element and the solar cell of the invention.

### <First Electrode 1>

The first electrode 1 includes the conductive support 11 and the photosensitive layer 13, and functions as a working electrode in the photoelectric conversion element 10.

As illustrated in Fig. 1 to Fig. 6, it is preferable that the first electrode 1 includes at least one of the porous layer 12, the blocking layer 14, the electron transport layer 15, or the hole transport layer 16.

It is preferable that the first electrode 1 includes at least the blocking layer 14 from the viewpoint of short-circuit prevention, and more preferably the porous layer 12 and the blocking layer 14 from the viewpoints of light absorption efficiency and short-circuit prevention.

In addition, it is preferable that the first electrode 1 includes the electron transport layer 15 or the hole transport layer 16, which is formed from an organic material, from the viewpoints of an improvement in productivity of the photoelectric conversion element, thickness reduction, and flexibilization.

### -Conductive Support 11 -

The conductive support 11 is not particularly limited as long as the conductive support 11 has conductivity and can support the photosensitive layer 13 and the like. It is preferable that the conductive support 11 has a configuration formed from a conductive material, for example, a metal, or a configuration including the support 11 a formed from glass or plastic and the transparent electrode 11b formed on a surface of the support 11a as a conductive film. In a case where the strength of the conductive support 11 is sufficiently maintained, the support 11a is not necessary.

Among these, as illustrated in Fig. 1 to Fig. 6, it is more preferable that the conductive support 11 has a configuration in which a conductive metal oxide is applied to the surface of the support 11a formed from glass or plastic to form the transparent electrode 11b. Examples of the support 11a formed from plastic include a transparent polymer film described in Paragraph 0153 of JP2001-291534A. As a material that forms the support 11a, it is possible to use ceramic (JP2005-135902A) and a conductive resin (JP2001-160425A) in addition to glass or plastic. As a metal oxide, a tin oxide (TO) is preferable, and an indium-tin oxide (a tin-doped indium oxide; ITO) or a tin oxide doped with fluorine such as a fluorine-doped tin oxide (FTO) more preferable. At this time, the amount of the metal oxide applied is preferably 0.1 to 100 g per square meter of a surface area of the support 11a. In a case of using the conductive support 11, it is preferable that light is incident from a support 11a side.

It is preferable that the conductive support 11 is substantially transparent. In the invention, "substantially transparent" represents that transmittance of light (having a wavelength of 300 to 1200 nm) is 10% or greater, preferably 50% or greater, and more preferably 80% or greater.

The thickness of the support 11a and the conductive support 11 is not particularly limited and is set to an appropriate thickness. For example, the thickness is preferably 0.01 µm to 10 mm, more preferably 0.1 µm to 5 mm, and still preferably 0.3 µm to 4 mm.

In a case of providing the transparent electrode 11b, the film thickness of the transparent electrode 11b is not particularly limited. For example, the film thickness is preferably 0.01 to 30 µm, more preferably 0.03 to 25 µm, and still more preferably 0.05 to 20 µm.

The conductive support 11 or the support 11a may have a light management function on the surface. For example, the conductive support 11 or the support 11 a may include an antireflection film formed by alternately laminating a high-refractive-index film and a low-refractive-index oxide film on the surface of the conductive support 11 or the support 11a as described in JP2003-123859A or may have a light guide function as described in JP2002-260746A.

### - Blocking Layer 14 -

In the invention, as in the photoelectric conversion elements 10A to 10C, and 10F, the blocking layer 14 is preferably provided on the surface of the transparent electrode 11b, that is, between the conductive support 11, and the porous layer 12, the photosensitive layer 13, the hole transport layer 3, or the like.

In the photoelectric conversion element and the solar cell, for example, when the photosensitive layer 13 or the hole transport layer 3, and the transparent electrode 11b and the like are electrically connected to each other, a reverse current is generated. The blocking layer 14 plays a role of preventing the reverse current. The blocking layer 14 is also referred to as a "short-circuit prevention layer".

The blocking layer 14 may be allowed to function as a stage that carries the light absorbing agent.

The blocking layer 14 may be provided even in a case where the photoelectric conversion element includes the electron transport layer. For example, in a case of the photoelectric conversion element 10D, the blocking layer 14 may be provided between the conductive support 11 and the electron transport layer 15. In a case of the photoelectric conversion element 10E, the blocking layer 14 may be provided between the second electrode 2 and the electron transport layer 4.

The material that forms the blocking layer 14 is not particularly limited as long as the material can perform the above-described function, and it is preferable that the material is a material through which visible light is transmitted, and which has insulating properties with respect to the conductive support 11 (transparent electrode 11b) and the like. Specifically, "material having insulating properties with respect to the conductive support 11 (transparent electrode 11b)" represents a compound (n-type semiconductor compound) having a conduction band energy level that is equal to or higher than a conduction band energy level of a material that forms the conductive support 11 (a metal oxide that forms the transparent electrode 11b) and is lower than a conduction band energy level of a material that constitutes the porous layer 12 or a ground state energy level of the light absorbing agent.

Examples of a material that forms the blocking layer 14 include silicon oxide, magnesium oxide, aluminum oxide, calcium carbonate, cesium carbonate, polyvinyl alcohol, polyurethane, and the like. In addition, the material may be a material that is typically used as a photoelectric conversion material, and examples thereof include titanium oxide, tin oxide, zinc oxide, niobium oxide, tungsten oxide, and the like. Among these, titanium oxide, tin oxide, magnesium oxide, aluminum oxide, and the like are preferred.

It is preferable that the film thickness of the blocking layer 14 is 0.001 to 10 µm, more preferably 0.005 to 1 µm, and still more preferably 0.01 to 0.1 µm.

In the invention, the film thicknesses of the respective layers can be measured by observing a cross-section of the photoelectric conversion element 10 by using a scanning electron microscope (SEM) and the like.

### - Porous Layer 12 -

In the invention, as in the photoelectric conversion elements 10A, 10B, and 10F, the porous layer 12 is preferably provided on the transparent electrode 11b. In a case where the blocking layer 14 is provided, the porous layer 12 is preferably formed on the blocking layer 14.

The porous layer 12 is a layer that functions as a stage that carries the photosensitive layer 13 on the surface. In a solar cell, so as to increase the light absorption efficiency, it is preferable to increase a surface area of at least a portion that receives light such as solar light, and it is more preferable to increase the surface area of the porous layer 12 as a whole.

It is preferable that the porous layer 12 is a fine particle layer that includes pores and is formed through vapor deposition or close contact of fine particles of a material that forms the porous layer 12. The porous layer 12 may be a fine particle layer that is formed through vapor deposition of two or more kinds of fine particles. In a case where the porous layer 12 is a fine particle layer that includes pores, it is possible to increase the amount (adsorption amount) of the light absorbing agent carried.

It is preferable to increase the surface area of individual fine particles which constitute the porous layer 12 so as to increase the surface area of the porous layer 12. In the invention, in a state in which the fine particles are applied to the conductive support 11 and the like, it is preferable that the surface area of the fine particles which form the porous layer 12 is 10 or more times a projected area, and more preferably 100 or more times the projected area. The upper limit thereof is not particularly limited. Typically, the upper limit is approximately 5000 times the projected area. With regard to a particle size of the fine particles which form the porous layer 12, an average particle size, which uses a diameter when converting the projected area into a circle, is preferably 0.001 to 1 µm as primary particles. In a case where the porous layer 12 is formed by using a dispersion of fine particles, the average particle size of the fine particles is preferably 0.01 to 100 µm in terms of an average particle size of the dispersion.

For the material that forms the porous layer 12, there is no particular limitation with respect to conductivity. The material may be an insulating substance (insulating material), a conductive material, or a semiconductor (semi-conductive material).

As the material that forms the porous layer 12, it is possible to use, for example, chalcogenides (for example, an oxide, a sulfide, a selenide, and the like) of metals, compounds having a perovskite-type crystal structure (excluding a perovskite compound that uses a light absorbing agent), oxides of silicon (for example, silicon dioxide, and zeolite), or carbon nanotubes (including carbon nanowires, carbon nanorods, and the like).

The chalcogenides of a metal are not particularly limited, and preferred examples thereof include respective oxides of titanium, tin, zinc, tungsten, zirconium, hafnium, strontium, indium, cerium, yttrium, lanthanum, vanadium, niobium, aluminum, and tantalum, cadmium sulfide, cadmium selenide, and the like. Examples of the crystal structure of the chalcogenides of metals include an anatase-type crystal structure, a brookite-type crystal structure, and a rutile-type crystal structure, and the anatase-type crystal structure and the brookite-type crystal structure are preferable.

The compound having a perovskite-type crystal structure is not particularly limited, and examples thereof include a transition metal oxide and the like. Examples of the transition metal oxide include strontium titanate, calcium titanate, barium titanate, lead titanate, barium zirconate, barium stannate, lead zirconate, strontium zirconate, strontium tantalate, potassium niobate, bismuth ferrate, barium strontium titanate, lanthanum barium titanate, calcium titanate, sodium titanate, and bismuth titanate. Among these, strontium titanate, calcium titanate, and the like are preferable.

The carbon nanotubes have a shape obtained by rounding off a carbon film (graphene sheet) into a tubular shape. The carbon nanotubes are classified into a single-walled carbon nanotube (SWCNT) obtained by winding one graphene sheet in a cylindrical shape, a double-walled carbon nanotube (DWCNT) obtained by winding two graphene sheets in a concentric shape, and a multi-walled carbon nanotube (MWCNT) obtained by winding a plurality of graphene sheets in a concentric shape. As the porous layer 12, any carbon nanotubes can be used without any particular limitation.

Among these, as the material that forms the porous layer 12, an oxide of titanium, tin, zinc, zirconium, aluminum, or silicon, or a carbon nanotube is preferable, and titanium oxide or aluminum oxide is more preferable.

The porous layer 12 may be formed from at least one kind of the chalcogenides of metals, the compound having a perovskite-type crystal structure, the oxide of silicon, or the carbon nanotube, or may be formed from a plurality of kinds thereof.

The film thickness of the porous layer 12 is not particularly limited. The thickness is typically in a range of 0.05 to 100 µm, and preferably in a range of 0.1 to 100 µm. In a case of being used as a solar cell, the film thickness is preferably 0.1 to 50 µm, and more preferably 0.2 to 30 µm.

### - Electron Transport Layer 15 -

In the invention, as in the photoelectric conversion element 10D, the electron transport layer 15 is preferably provided on the surface of the transparent electrode 11b.

The electron transport layer 15 has a function of transporting electrons, which are generated in the photosensitive layer 13, to the conductive support 11. The electron transport layer 15 is formed from an electron transporting material capable of exhibiting the above-described function. The electron transporting material is not particularly limited, and an organic material (organic electron transporting material) is preferable. Examples of the organic electron transporting material include fullerene compounds such as [6,6]-phenyl-C61-butyric acid methyl ester (PC₆₁BM), perylene compounds such as perylene tetracarboxylic diimide (PTCDI), low-molecular-weight compounds such as tetracyanoquinodimethane (TCNQ), high-molecular-weight compounds, and the like.

Although not particularly limited, it is preferable that the film thickness of the electron transport layer 15 is 0.001 to 10 µm, and more preferably 0.01 to 1 µm.

### - Hole Transport Layer 16 -

In the invention, as in the photoelectric conversion element 10E, the hole transport layer 16 is preferably provided on the surface of the transparent electrode 11b.

The hole transport layer 16 is the same as the hole transport layer 3 to be described later except for a different formation position.

### - Photosensitive Layer (Light Absorbing Layer) 13 -

The photosensitive layer 13 is preferably provided on the surface (including an inner surface of a concave portion in a case where a surface on which the photosensitive layer 13 is provided is uneven) of each of the porous layer 12 (in the photoelectric conversion elements 10A, 10B, and 10F), the blocking layer 14 (in the photoelectric conversion element 10C), the electron transport layer 15 (in the photoelectric conversion element 10D), and the hole transport layer 16 (in the photoelectric conversion element 10E).

In the invention, the perovskite-type light absorbing agent may contain at least one kind of specific perovskite compound to be described later, or two or more kinds of perovskite compounds.

In addition, the photosensitive layer 13 may include a light absorbing agent other than the perovskite compound in combination with the perovskite-type light absorbing agent. Examples of the light absorbing agent other than the perovskite compound include a metal complex dye, and an organic dye. At this time, a ratio between the perovskite-type light absorbing agent and the light absorbing agent other than the perovskite-type light absorbing agent is not particularly limited.

The photosensitive layer 13 may be a monolayer or a laminated layer of two or more layers. In a case where the photosensitive layer 13 has the laminated layer structure of two or more layers, the laminated layer structure may be a laminated layer structure obtained by laminating layers formed from light absorbing agents different from each other, or a laminated layer structure including an interlayer including a hole transporting material between a photosensitive layer and a photosensitive layer. In a case where the photosensitive layer 13 has the laminated layer structure of two or more layers, the metal cation M2 may be contained in a layer that includes the perovskite-type light absorbing agent. In a case where two or more layers including the perovskite-type light absorbing agent exist, the metal cation M2 may be included in any layer or in all layers as long as the metal cation M2 is included in at least one layer.

As an aspect in which the photosensitive layer 13 is provided on the conductive support 11 is as described above. The photosensitive layer 13 is preferably provided on a surface of each of the layers in order for an excited electron to flow to the conductive support 11 or the second electrode 2. At this time, the photosensitive layer 13 may be provided on the entirety or a part of the surface of each of the layers.

The film thickness of the photosensitive layer 13 is appropriately set in correspondence with an aspect in which the photosensitive layer 13 is provided on the conductive support 11, and is not particularly limited. Typically, for example, the film thickness is preferably 0.001 to 100 µm, more preferably 0.01 to 10 µm, and still more preferably 0.01 to 5 µm.

In a case where the porous layer 12 is provided, a total film thickness including the film thickness of the porous layer 12 is preferably 0.01 µm or greater, more preferably 0.05 µm or greater, still more preferably 0.1 µm or greater, and still more preferably 0.3 µm or greater. In addition, the total film thickness is preferably 100 µm or less, more preferably 50 µm or less, and still more preferably 30 µm or less. The total film thickness may be set to a range in which the above-described values are appropriately combined. Here, as illustrated in Fig. 1, in a case where the photosensitive layer 13 has a thin film shape, the film thickness of the photosensitive layer 13 represents a distance between an interface with the porous layer 12, and an interface with the hole transport layer 3 to be described later along a direction that is perpendicular to the surface of the porous layer 12.

In the photoelectric conversion element 10, in a case where the porous layer 12 and the hole transport layer 3 are provided, a total film thickness of the porous layer 12, the photosensitive layer 13, and the hole transport layer 3 is not particularly limited. For example, the total thickness is preferably 0.01 µm or greater, more preferably 0.05 µm or greater, still more preferably 0.1 µm or greater, and still more preferably 0.3 µm or greater. In addition, the total film thickness is preferably 200 µm or less, more preferably 50 µm or less, still more preferably 30 µm or less, and still more preferably 5 µm or less. The total film thickness can be set to a range in which the above-described values are appropriately combined.

In the invention, in a case where the photosensitive layer is provided in a thick film shape (in the photosensitive layer 13B and 13C), the light absorbing agent that is included in the photosensitive layer may function as a hole transporting material.

The amount of the perovskite compound used is preferably set to an amount capable of covering at least a part of a surface of the first electrode 1, and more preferably an amount capable of covering the entirety of the surface.

### [Perovskite-Type Light Absorbing Agent]

The photosensitive layer 13 contains a perovskite compound that includes "an element of Group 1 in the periodic table or a cationic organic group A", "a metal atom M1 other than elements of Group 1 in the periodic table", and "an anionic atom or atomic group X" as the perovskite-type light absorbing agent.

In the perovskite compound, the element of Group 1 in the periodic table or the cationic organic group A, and the anionic atom or atomic group X exists as individual constituent ions of a cation (for convenience, may be referred to as "cation A") and an anion (for convenience, may be referred to as "anion X") in the perovskite-type crystal structure. In addition, the metal atom M1 exists as a metal cation (for convenience, may be referred to as "cation M1") as a central ion in the perovskite-type crystal structure.

In the invention, the cationic organic group represents an organic group having a property of becoming a cation in the perovskite-type crystal structure, and the anionic atom or atomic group represents an atom or atomic group that has a property of becoming an anion in the perovskite-type crystal structure.

In the perovskite compound that is used in the invention, the cation A represents a cation of an element of Group 1 in the periodic table or an organic cation that is composed of a cationic organic group A. The cation A is preferably an organic cation.

The cation of an element of Group 1 in the periodic table is not particularly limited, and examples thereof include cations (Li⁺, Na⁺, K⁺, and Cs⁺) of individual elements of lithium (Li), sodium (Na), potassium (K), and cesium (Cs), and the cation (Cs⁺) of cesium is more preferable.

The organic cation is not particularly limited as long as the organic cation is a cation of an organic group having the above-described property, but an organic cation of a cationic organic group represented by the following Formula (1) is more preferable.

Formula (1): R^{1a}-NH₃

In Formula (1), R^{1a} represents a substituent group. R^{1a} is not particularly limited as long as R^{1a} is an organic group, but an alkyl group, a cycloalkyl group, an alkenyl group, an alkynyl group, an aryl group, a heteroaryl group, or a group represented by the following Formula (2) is preferable. Among these, the alkyl group and a group represented by the following Formula (2) are more preferable.

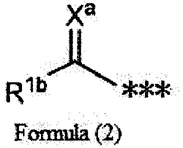

In Formula (2), X^{a} represents NR^{1c}, an oxygen atom, or a sulfur atom. R^{1b} and R^{1c} each independently represent a hydrogen atom or a substituent group. *** represents bonding with a nitrogen atom in Formula (1).

In the invention, as the organic cation of the cationic organic group A, an organic ammonium cation (R^{1a}-NH₃⁺) composed of an ammonium cationic organic group A obtained through bonding between R^{1a} and NH₃ in Formula (1) is preferable. In a case where the organic ammonium cation can employ a resonance structure, the organic cation further includes a cation having the resonance structure in addition to the organic ammonium cation. For example, in a case where X^{a} is NH (R^{1c} is a hydrogen atom) in a group represented by Formula (2), the organic cation also includes an organic amidinium cation that is one of a resonance structure of the organic ammonium cation in addition to the organic ammonium cation of the ammonium cationic organic group obtained through bonding between the group represented by Formula (2) and NH₃. Examples of the organic amidinium cation composed of the amidinium cationic organic group include a cation represented by the following Formula (A^{am}). In this specification, the cation represented by the following Formula (A^{am}) may be noted as "R^{1b}C(=NH)-NH₃⁺" for convenience.

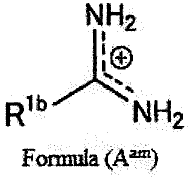

The alkyl group is preferably an alkyl group having 1 to 18 carbon atoms, more preferably an alkyl group having 1 to 6 carbon atoms, and still more preferably an alkyl group having 1 to 3 carbon atoms. Examples of the alkyl group include methyl, ethyl, propyl, isopropyl, butyl, tert-butyl, pentyl, hexyl, and the like.

The cycloalkyl group is preferably a cycloalkyl group having 3 to 8 carbon atoms, and examples thereof include cyclopropyl, cyclopentyl, cyclohexyl, and the like.

The alkenyl group is preferably an alkenyl group having 2 to 18 carbon atoms, and more preferably an alkenyl group having 2 to 6 carbon atoms. Examples of the alkenyl group include vinyl, allyl, butenyl, hexenyl, and the like.

The alkynyl group is preferably an alkynyl group having 2 to 18 carbon atoms, and more preferably an alkynyl group having 2 to 4 carbon atoms. Examples of the alkynyl group include ethynyl, butynyl, hexynyl, and the like.

The aryl group is preferably an aryl group having 6 to 14 carbon atoms, and more preferably an aryl group having 6 to 12 carbon atoms, and examples thereof include phenyl.

The heteroaryl group includes a group composed of an aromatic hetero ring alone, and a group composed of a condensed hetero ring obtained through condensing of another ring, for example, an aromatic ring, an aliphatic ring, or a hetero ring with the aromatic hetero ring. As the ring-constituting hetero atom that constitutes the aromatic hetero ring, a nitrogen atom, an oxygen atom, or a sulfur atom is preferable. In addition, with regard to the number of ring members of the aromatic hetero ring, three-membered to eight-membered rings are preferable, and a five-membered ring or a six-membered ring is more preferable.

Examples of the five-membered aromatic hetero ring and the condensed hetero ring including the five-membered aromatic hetero ring include respective cyclic groups of a pyrrole ring, an imidazole ring, a pyrazole ring, an oxazole ring, a thiazole ring, a triazole ring, a furan ring, a thiophene ring, a benzimidazole ring, a benzoxazole ring, a benzothiazole ring, an indoline ring, and an indazole ring. In addition, examples of the six-membered aromatic hetero ring and the condensed hetero ring including the six-membered aromatic hetero ring include respective cyclic groups of a pyridine ring, a pyrimidine ring, a pyrazine ring, a triazine ring, a quinoline ring, and a quinazoline ring.

In the group represented by Formula (2), X^{a} represents NR^{1c}, an oxygen atom, or a sulfur atom, and NR^{1c} is preferable as X^{a}. Here, R^{1c} represents a hydrogen atom or a substituent group. R^{1c} is preferably a hydrogen atom, an alkyl group, a cycloalkyl group, an alkenyl group, an alkynyl group, an aryl group, or a heteroaryl group, and more preferably a hydrogen atom.

R^{1b} represents a hydrogen atom or a substituent group, and is preferably a hydrogen atom. Examples of the substituent group that can be employed as R^{1b} include an amino group, an alkyl group, a cycloalkyl group, an alkenyl group, an alkynyl group, an aryl group, a heteroaryl group.

An alkyl group, a cycloalkyl group, an alkenyl group, an alkynyl group, an aryl group, and a heteroaryl group that can be respectively employed by R^{1b} and R^{1c} are the same as the respective groups of R^{1a}, and preferred examples thereof are the same as described above.

Examples of the group represented by Formula (2) include a (thio)acyl group, a (thio)carbamoyl group, an imidoyl group, and an amidino group.

Examples of the (thio)acyl group include an acyl group and a thioacyl group. The acyl group is preferably an acyl group having a total of 1 to 7 carbon atoms, and examples thereof include formyl, acetyl (CH₃C(=O)-), propionyl, hexanoyl, and the like. The thioacyl group is preferably a thioacyl group having a total of 1 to 7 carbon atoms, and examples thereof include thioformyl, thioacetyl (CH₃C(=S)-), thiopropionyl, and the like.

Examples of the (thio)carbamoyl group include a carbamoyl group (H₂NC(=O)-) and a thiocarbamoyl group (H₂NC(=S)-).

The imidoyl group is a group represented by R^{1b}-C(=NR^{1c})-, and it is preferable that R^{1b} and R^{1c} are respectively a hydrogen atom and an alkyl group. More preferably, the alkyl group is the same as the alkyl group as R^{1a}. Examples thereof include formimidoyl (HC(=NH)-), acetoimidoyl (CH₃C(=NH)-), propionimidoyl (CH₃CH₂C(=NH)-), and the like. Among these, formimidoyl is preferable.

The amidino group as the group represented by Formula (2) has a structure (-C(=NH)NH₂) in which R^{1b} of the imidoyl group is an amino group and R^{1c} is a hydrogen atom.

The entirety of the alkyl group, the cycloalkyl group, the alkenyl group, the alkynyl group, the aryl group, the heteroaryl group, and the group represented by Formula (2), which can be employed as R^{1a}, may have a substituent group. The substituent group, which R^{1a} may have, is not particularly limited, and examples thereof include an alkyl group, a cycloalkyl group, an alkenyl group, an alkynyl group, an aryl group, a heterocyclic group, an alkoxy group, an alkylthio group, an amino group, an alkylamino group, an arylamino group, an acyl group, an alkylcarbonyloxy group, an aryloxy group, an alkoxycarbonyl group, an aryloxycarbonyl group, an acylamino group, a sulfonamido group, a carbamoyl group, a sulfamoyl group, a halogen atom, a cyano group, a hydroxy group, and a carboxy group. The substituent group, which R^{1a} may have, may be additionally substituted with a substituent group.

In the perovskite compound that is used in the invention, the metal cation M1 is not particularly limited as long as the metal cation M1 is a cation of a metal atom other than elements of Group 1 in the periodic table and is a cation of a metal atom that can employ the perovskite-type crystal structure. Examples of the metal atom include metal atoms such as calcium (Ca), strontium (Sr), cadmium (Cd), copper (Cu), nickel (Ni), manganese (Mn), iron (Fe), cobalt (Co), palladium (Pd), germanium (Ge), tin (Sn), lead (Pb), ytterbium (Yb), europium (Eu), indium (In), titanium (Ti), and bismuth (Bi). M1 may be one kind of metal cation, or two or more kinds of metal cations. Among these, the metal cation M1 is preferably a divalent cation, more preferably at least one kind selected from the group consisting of a divalent lead cation (Pb²⁺), a divalent copper cation (Cu²⁺), a divalent germanium cation (Ge²⁺), and a divalent tin cation (Sn²⁺), still more preferably Pb²⁺ or Sn²⁺, and still more preferably Pb²⁺.

In a case where the metal cation M1 includes two or more kinds of metal cations, a ratio of the metal cations is not particularly limited. For example, in a case where two kinds including Pb²⁺ and Sn²⁺ are used in combination as the metal cation M1, a molar ratio (Pb²⁺: Sn²⁺) between Pb²⁺ and Sn²⁺ is preferably 99.9:0.1 to 0.1:99.9, and more preferably 99:1 to 50:50.

In the perovskite compound that is used in the invention, the anion X represents an anion of an anionic atom or atomic group X. Preferred examples of the anion include anions of halogen atoms, and anions of individual atomic groups of NC⁻, NCS⁻, NCO⁻, HO⁻, NO₃⁻, CH₃COO⁻, and HCOO⁻. Among these, the anions of halogen atoms are more preferable. Examples of the halogen atoms include a fluorine atom, a chlorine atom, a bromine atom, an iodine atom, and the like.

The anion X may be an anion of one kind of anionic atom or atomic group, or anions of two or more kinds of anionic atoms or atomic groups. In a case where the anion X is an anion of one kind of anionic atom or atomic group, an anion of an iodine atom is preferable. On the other hand, in a case where the anion X includes anions of two or more kinds of anionic atoms or atomic groups, anions of two kinds of halogen atoms, particularly, an anion of a chlorine atom and an anion of an iodine atom are preferable. A ratio between two or more kinds of anions is not particularly limited.

As the perovskite compound that is used in the invention, a perovskite compound, which has a perovskite-type crystal structure including the above-described constituent ions and is represented by the following Formula (I), is preferable.

Formula (I): Aₐ(M1)ₘXₓ

In Formula (I), A represents an element of Group 1 in the periodic table or a cationic organic group. M1 represents a metal atom other than elements of Group 1 in the periodic table. X represents an anionic atom or atomic group.
a represents 1 or 2, m represents 1, and a, m, and x satisfy a relationship of a+2m=x.

In Formula (I), the element of Group 1 in the periodic table or the cationic organic group A forms the cation A of the perovskite-type crystal structure. Accordingly, there is no particular limitation as long as the element of Group 1 in the periodic table and the cationic organic group A are elements or groups which become the cation A and can constitute the perovskite-type crystal structure. The element of Group 1 in the periodic table or the cationic organic group A is the same as the element of Group 1 in the periodic table or the cationic organic group which is described in the above-described cation A, and preferred examples thereof are the same as described above.

The metal atom M1 is a metal atom that forms the metal cation M1 as a central ion of the perovskite-type crystal structure. Accordingly, the metal atom M1 is not particularly limited as long as the metal atom M1 is an atom that is an atom other than elements of Group 1 in the periodic table, becomes the metal cation M1, and forms the central ion of the perovskite-type crystal structure. The metal atom M1 is the same as the metal atom that becomes the metal atom or the metal cation M1 which is described in the above-described metal cation M1, and preferred examples thereof are the same as described above.

The anionic atom or atomic group X forms the anion X of the perovskite-type crystal structure. Accordingly, the anionic atom or atomic group X is not particularly limited as long as the anionic atom or atomic group X is an atom or atomic group that becomes the anion X and can constitute the perovskite-type crystal structure. The anionic atom or atomic group X is the same as the anionic atom or atomic group which is described in the above-described anion X, and preferred examples thereof are the same as described above.

The perovskite compound represented by Formula (I) is a perovskite compound represented by the following Formula (I-1) in a case where a is 1, or a perovskite compound represented by the following Formula (1-2) in a case where a is 2.

Formula (I-1): A(M1)X₃

Formula (I-2): A₂(M1)X₄

In Formula (1-1) and Formula (I-2), A represents an element of Group 1 in the periodic table or a cationic organic group. A is the same as A in Formula (I), and preferred examples thereof are the same as described above.

M1 represents a metal atom other than elements of Group 1 in the periodic table. M1 is the same as M1 in Formula (I), and preferred examples thereof are the same as described above.

X represents an anionic atom or atomic group. X is the same as X in Formula (I), and preferred examples thereof are the same as described above.

The perovskite compound that is used in the invention may be any one of the compound represented by Formula (1-1) and the compound represented by Formula (1-2), or a mixture thereof. Accordingly, in the invention, at least one kind of the perovskite compound may exist as the light absorbing agent, and there is no need for clear and strict distinction on that the perovskite compound is which compound by using a composition formula, a molecular formula, a crystal structure, and the like.

Hereinafter, specific examples of the perovskite compound that can be used in the invention will be exemplified, but the invention is not limited to the specific examples. In the following description, the perovskite compound is classified into the compound represented by Formula (I-1) and the compound represented by Formula (1-2). However, even the compound exemplified as the compound represented by Formula (I-1) may be the compound represented by Formula (I-2) in accordance with synthesis conditions, or may be a mixture of the compound represented by Formula (I-1) and the compound represented by Formula (1-2). Similarly, even the compound exemplified as the compound represented by Formula (I-2) may be the compound represented by Formula (I-1), or may be a mixture of the compound represented by Formula (1-1) and the compound represented by Formula (I-2).

Specific examples of the compound represented by Formula (I-1) include CH₃NH₃PbCl₃, CH₃NH₃PbBr₃, CH₃NH₃PbI₃, CH₃NH₃PbBrI₂, CH₃NH₃PbBr₂I, CH₃NH₃SnBr₃, CH₃NH₃SnI₃, CH₃NH₃GeCl₃, CH(=NH)NH₃PbI₃, CsSnI₃, and CsGeI₃.

Specific examples of the compound represented by Formula (I-2) include (C₂H₅NH₃)₂PbI₄, (C₁₀H₂₁NH₃)₂PbI₄, (CH₂=CHNH₃)₂PbI₄, (CH≡CNH₃)₂PbI₄, (n-C₃H₇NH₃)₂PbI₄, (n-C₄H₉NH₃)₂PbI₄, (C₆H₅NH₃)₂PbI₄, (C₆H₅CH₂CH₂NH₃)₂PbI₄, (C₆H₃F₂NH₃)₂PbI₄, (C₆F₅NH₃)₂PbI₄, (C₄H₃SNH₃)₂PbI₄, (CH₃NH₃)₂CuCl₄, (C₄H₉NH₃)₂GeI₄, (C₃H₇NH₃)₂FeBr₄. Here, C₄H₃SNH₃ in (C₄H₃SNH₃)₂PbI₄ represents aminothiophene.

The perovskite compound can be synthesized from a compound represented by Formula (II) and a compound represented by Formula (III).

Formula (II): AX

Formula (III): (M1)X₂

In Formula (II), A represents an element of Group 1 in the periodic table, or a cationic organic group. A is the same as A in Formula (I), and preferred examples thereof are the same as described above. In Formula (II), X represents an anionic atom or atomic group. X is the same as X in Formula (I), and preferred examples thereof are the same as described above.

In Formula (III), M1 represents a metal atom other than elements of Group 1 in the periodic table. M1 is the same as M1 in Formula (I), and preferred examples thereof are the same as described above. In Formula (III), X represents an anionic atom or atomic group. X is the same as X in Formula (I), and preferred examples thereof are the same as described above.

Examples of a method of synthesizing the perovskite compound include a method described in Science, 2012, vol. 338, p. 643 to 647. Another example thereof also includes a method described in Akihiro Kojima, Kenjiro Teshima, Yasuo Shirai, and Tsutomu Miyasaka, "Organometal Halide Perovskites as Visible-Light Sensitizers for Photovoltaic Cells", J. Am. Chem. Soc., 2009, 131(17), p. 6050-6051.

The amount of the perovskite-type light absorbing agent used is preferably set to an amount capable of covering at least a part of the surface of the first electrode 1, and more preferably an amount capable of covering the entirety of the surface.

The amount of the perovskite compound contained in the photosensitive layer 13 is typically 1% to 100% by mass.

In the photosensitive layer 13, the perovskite-type light absorbing agent includes the metal cation M2. A valence of the metal cation M2 is different from that of the metal cation M1. The metal cation M2 is not particularly limited as long as the metal cation M2 is a metal cation of a metal atom other than elements of Group 1 in the periodic table. The metal cation M2 may be a cation of the same element as that of the metal cation M1 or may be a cation of an element different from that of the metal cation M1. In the invention, it is preferable that the metal cation M1 and the metal cation M2 are cations of elements different from each other.

A valence of the metal cation M2 is not particularly limited as long as the valence is different from that of the metal cation M1, and is preferably a valence greater than the valence of the metal cation M1. For example, a trivalence to a septivalence can be exemplified. A trivalence to a hexavalence are preferable, and a tetravalence is more preferable.

Examples of the metal cation M2 as described above include cations of respective elements of Groups 3 to Group 14 in the periodic table. Among these, cations of respective elements of Group 6 to Group 14 in the periodic table are preferable, cations of respective elements of Group 7 to Group 14 are more preferable, and cations of respective elements of Group 14 are still more preferable.

As the metal cation M2, at least one kind, which is selected from the group consisting of a monovalent copper cation, a monovalent silver cation, a trivalent ruthenium cation, a trivalent vanadium cation, a trivalent indium cation, a trivalent cobalt cation, a trivalent aluminum cation, a trivalent bismuth cation, a trivalent chromium cation, a trivalent gallium cation, a trivalent iron cation, a trivalent neodymium cation, a trivalent samarium cation, a trivalent dysprosium cation, a trivalent thulium cation, a tetravalent lead cation (Pb⁴⁺), a tetravalent zirconium cation, a tetravalent titanium cation, a tetravalent germanium cation, a tetravalent tungsten cation, a tetravalent tin cation (Sn⁴⁺), a pentavalent molybdenum cation, and a hexavalent chromium cation, is more preferable. Among these, Sn⁴⁺ and Pb⁴⁺ are still more preferable, and Sn⁴⁺ is still more preferable.

In the invention, a combination of the metal cations M1 and M2 is not particularly limited as long as valences of the respective cations are different from each other. As the combination, a combination in which the valence of the metal cation M2 is greater than the valence of the metal cation M1 is preferable, a combination in which the metal cation M1 is Pb²⁺ and the metal cation M2 is Pb⁴⁺ and a combination in which the metal cation M1 is Pb²⁺ and the metal cation M2 is Sn⁴⁺ are more preferable, and a combination in which the metal cation M1 is Pb²⁺ and the metal cation M2 is Sn⁴⁺ is still more preferable.

The amount of the metal cation M1 contained in the perovskite-type light absorbing agent is not particularly limited as long as the metal cation M1 exists in an amount capable of forming a predetermined amount of perovskite-type light absorbing agent. For example, the amount of the metal cation M1 contained is preferably 0.01% to 99.9% by mass, and more preferably 1% to 99% by mass. In addition, the amount of the metal cation M2 contained in the perovskite-type light absorbing agent is not particularly limited, and may be greater or less than or the same as the amount of the metal cation M1 contained. Preferably, the amount of the metal cation M2 contained is less than the amount of the metal cation M1 contained. For example, the amount of the metal cation M2 contained is preferably 0.001% to 99.9% by mass, and more preferably 0.001% to 10.0% by mass.

In the invention, the amount of the metal cation M1 contained represents the amount of the metal cation M1 that exists in the perovskite-type light absorbing agent, and is a total amount of metal cations which form the perovskite-type light absorbing agent and metal cations which do not form the perovskite-type light absorbing agent. In addition, the amount of the metal cation M2 represents the amount of the metal cation M2 contained in the perovskite-type light absorbing agent.

In a case where a plurality of kinds of the metal cations M1 and a plurality of kinds of the metal cations M2 respectively exist, the amount is set to a total amount thereof.

In the invention, a ratio of the amount of the metal cation M1 contained to the amount of the metal cation M2 contained is preferably 19 to 499 and more preferably 49 to 199 in terms of a molar ratio ([M1/[M2]) from the viewpoints of the current value and the variation in the photoelectric conversion efficiency. Here, [M1] and [M2] respectively represent the amount of the metal cation M1 1 and the amount of the metal cation M2 in terms of a mole.

In the invention, particularly, in a case where the valence of the metal cation M2 is greater than the valence of the metal cation M1, it is preferable that the amount of the metal cation M2 contained is less than the amount of the metal cation M1 contained. In this case, it is preferable that a ratio between the amount of the metal cation M1 contained and the amount of metal cation M2 contained is the same as the above-described ratio.

In the invention, in a case of measuring the amount of the individual cations contained, it is possible to appropriately employ the analysis method of confirming whether or not the perovskite-type light absorbing agent includes the metal cation M2.

In the invention, the amount of the metal cation M1 contained and the amount of the metal cation M2 contained may be substituted with the amount of a material such as the following metal salt composition that forms the perovskite-type light absorbing agent (photosensitive layer).

### <Hole Transport Layer 3>

As in the photoelectric conversion elements 10A to 10D, in a preferred aspect of the photoelectric conversion element of the invention, the hole transport layer 3 is provided between the first electrode 1 and the second electrode 2. The hole transport layer 3 is preferably provided between the photosensitive layer 13 of the first electrode 1 and the second electrode 2.

The hole transport layer 3 includes a function of supplementing electrons to an oxidized substance of the light absorbing agent, and is preferably a solid-shaped layer (solid hole transport layer).

A hole transporting material that forms the hole transport layer 3 may be a liquid material or a solid material, and there is no particular limitation thereto. Examples of the hole transporting material include inorganic materials such as CuI and CuNCS, organic hole transporting materials described in Paragraphs 0209 to 0212 of JP2001-291534A, and the like. Preferred examples of the organic hole transporting material include conductive polymers such as polythiophene, polyaniline, polypyrrole, and polysilane, spiro compounds in which two rings share a central atom such as C or Si having a tetrahedral structure, aromatic amine compounds such as triarylamine, triphenylene compounds, nitrogen-containing heterocyclic compounds, and liquid-crystalline cyano compounds.

As the hole transporting material, an organic hole transporting material which can be applied in a solution state and then has a solid shape is preferable, and specific examples thereof include 2,2',7,7'-tetrakis-(N,N-di-p-methoxyphenylamino)-9,9'-spirobifluorene (also referred to as "spiro-MeOTAD"), poly(3-hexylthiophene-2,5-diyl), 4-(diethylamino)benzaldehyde, diphenylhydrazone, polyethylene dioxythiophene (PEDOT), and the like.

Although not particularly limited, the film thickness of the hole transport layer 3 is preferably 50 µm or less, more preferably 1 nm to 10 µm, still more preferably 5 nm to 5 µm, and still more preferably 10 nm to 1 µm.

### <Electron Transport Layer 4>

As in the photoelectric conversion element 10E, in a preferred aspect of the photoelectric conversion element of the invention, the electron transport layer 4 is provided between the first electrode 1 and the second electrode 2. In this aspect, it is preferable that the electron transport layer 4 is in contact with (laminated on) the photosensitive layer 13C.

The electron transport layer 4 is the same as the electron transport layer 15 except that an electron transporting destination is the second electrode, and a formation position is different.

### <Second Electrode 2>

The second electrode 2 functions as a positive electrode or a negative electrode in a solar cell. The second electrode 2 is not particularly limited as long as the second electrode 2 has conductivity. Typically, the second electrode 2 can be configured to have the same configuration as that of the conductive support 11. In a case where sufficient strength is maintained, the support 11a is not necessary.

As a structure of the second electrode 2, a structure having a high current-collection effect is preferable. At least one of the conductive support 11 or the second electrode 2 needs to be substantially transparent so that light reaches the photosensitive layer 13. In the solar cell of the invention, it is preferable that the conductive support 11 is transparent and solar light is incident from the support 11a side. In this case, it is more preferable that the second electrode 2 has a light-reflecting property.

Examples of a material used to form the second electrode 2 include metals such as platinum (Pt), gold (Au), nickel (Ni), copper (Cu), silver (Ag), indium (In), ruthenium (Ru), palladium (Pd), rhodium (Rh), iridium (Ir), osmium (Os), and aluminum (Al), the above-described conductive metal oxides, carbon materials, conductive polymers, and the like. The carbon materials may be conductive materials formed through bonding of carbon atoms, and examples thereof include fullerene, a carbon nanotube, graphite, graphene, and the like.

As the second electrode 2, a thin film (including a thin film obtained through vapor deposition) of a metal or a conductive metal oxide, or a glass substrate or a plastic substrate which has the thin film is preferable. As the glass substrate or the plastic substrate, glass including a gold or platinum thin film or glass on which platinum is vapor-deposited is preferable.

The film thickness of the second electrode 2 is not particularly limited, and is preferably 0.01 to 100 µm, more preferably 0.01 to 10 µm, and still more preferably 0.01 to 1 µm.

### <Other Configurations>

In the invention, a spacer or a separator can also be used instead of the blocking layer 14 and the like or in combination with the blocking layer 14 and the like so as to prevent the first electrode 1 and the second electrode 2 from coming into contact with each other.

In addition, a hole blocking layer may be provided between the second electrode 2 and the hole transport layer 3.

### <<Solar Cell>>

The solar cell of the invention is constituted by using the photoelectric conversion element of the invention. For example, as illustrated in Fig. 1 to Fig. 6, the photoelectric conversion element 10 constituted by providing the external circuit 6 can be used as the solar cell. As the external circuit that is connected to the first electrode 1 (the conductive support 11) and the second electrode 2, a known circuit can be used without particular limitation.

For example, the invention is applicable to individual solar cells described in Science, 2012, vol. 338, p. 643 to 647, and J. Am. Chem. Soc., 2009, 131(17), p. 6050-6051.

It is preferable that a lateral surface of the solar cell of the invention is sealed with a polymer, an adhesive, and the like so as to prevent deterioration, evaporation, and the like in constituent substances.

As described above, in the photoelectric conversion element and the solar cell of the invention, the perovskite-type light absorbing agent includes the metal cation M2, and thus a current value is high and a variation in photoelectric conversion efficiency between elements is reduced.

### <<Method of Manufacturing Photoelectric Conversion Element and Solar Cell>>

The photoelectric conversion element and the solar cell of the invention can be manufactured in accordance with a known method, for example, a method described in Science, 2012, vol. 338, p. 643 to 647, J. Am. Chem. Soc., 2009, 131(17), p. 6050-6051, and the like except for formation of the photosensitive layer.

Hereinafter, the method of manufacturing the photoelectric conversion element and the solar cell of the invention will be described in brief.

The method of manufacturing the photoelectric conversion element and the solar cell of the invention (hereinafter, referred to as "manufacturing method of the invention") includes a process of bringing a metal salt MS1 in which the metal cation M1 as a central ion of the perovskite-type crystal structure is set as a cation, a metal salt MS2 in which the metal cation M2, of which a valence is different from a valence of the metal cation M1, of a metal atom other than elements of Group 1 in the periodic table is set as a cation, and a salt AX in which a cation A other than the central ion of the perovskite-type crystal structure is set as a cation into contact with each other on a surface of a layer on which a photosensitive layer is to be formed so as to form a perovskite-type light absorbing agent on the surface.

In the manufacturing method of the invention, the other processes are not particularly limited as long as the above-described process is provided.

In the manufacturing method of the invention, first, at least one of the blocking layer 14, the porous layer 12, the electron transport layer 15, or the hole transport layer 16 is formed on a surface of the conductive support 11 according to the purpose.

For example, the blocking layer 14 can be formed by a method in which a dispersion, which contains the insulating substance or a precursor compound thereof, and the like, is applied to the surface of the conductive support 11, and the dispersion is baked, a spray pyrolysis method, and the like.

A material that forms the porous layer 12 is preferably used as fine particles, and more preferably a dispersion that contains the fine particles.

A method of forming the porous layer 12 is not particularly limited, and examples thereof include a wet-type method, a dry-type method, and other methods (for example, a method described in Chemical Review, Vol. 110, p. 6595 (published on 2010)). In these methods, it is preferable that the dispersion (paste) is applied to the surface of the conductive support 11 or the surface of the blocking layer 14 and then the dispersion is baked at a temperature 100°C to 800°C for ten minutes to ten hours, for example, in the air. According to this, it is possible to bring the fine particles into close contact with each other.

In a case where baking is performed a plurality of times, a temperature in baking except final baking (a baking temperature except for a final baking temperature) is preferably set to be lower than the temperature in the final baking (the final baking temperature). For example, in a case where titanium oxide paste is used, the baking temperature except for the final baking temperature can be set in a range of 50°C to 300°C. In addition, the final baking temperature can be set in a range of 100°C to 600°C to be higher than the baking temperature except for the final baking temperature. In a case where a glass support is used as the support 11a, the baking temperature is preferably 60°C to 500°C.

The amount of a porous material applied to form the porous layer 12 is appropriately set in correspondence with the film thickness of the porous layer 12, the number of times of coating, and the like, and there is no particular limitation thereto. For example, the amount of the porous material applied per surface area 1 m² of the conductive support 11 is preferably 0.5 to 500 g, and more preferably 5 to 100 g.

In a case where the electron transport layer 15 or the hole transport layer 16 is provided, the layer can be formed in the same manner as in the hole transport layer 3 or the electron transport layer 4 to be described below.

Subsequently, the photosensitive layer 13 is provided.

When forming the photosensitive layer 13, a compound capable of synthesizing the perovskite-type light absorbing agent, and a compound that generates the metal cation M2 are used.

Examples of the compound capable of synthesizing the perovskite-type light absorbing agent include a compound (salt AX) represented by Formula (II), and a compound (M1)X₂ (metal salt MS1) represented by Formula (III). Examples of the compound that generates the metal cation M2 include a compound composed of the metal cation M2 and an anion X that is a counter anion of the metal cation M2, and specific examples thereof are as described above.

The compounds may be used alone, or as a composition (including types such as solution, suspension, and paste).

In the invention, the photosensitive layer 13 can be formed by using a composition that contains the entirety of the compounds. When considering that the metal cation M2 is efficiently contained in the perovskite-type light absorbing agent, and a uniform film can be formed, it is preferable that the following metal salt composition is brought into contact with a surface of a layer on which the photosensitive layer is to be formed, and then the salt AX is brought into contact with the surface to form the photosensitive layer.

In the preferred method in which the metal salt composition and the salt AX are sequentially brought into contact with the surface, as the metal salt composition, it is preferable to use a metal salt MS1 in which the metal cation M1 as the central ion of the perovskite-type crystal structure is set as a cation, a metal salt MS2 in which the metal cation M2 of a metal atom other than elements of Group 1 in the periodic table is set as a cation, and of which a valence is different from the valence of the metal cation M1, and a metal salt composition that contains an organic solvent (a metal salt composition of the invention). The metal salt composition may contain other components.

The metal salt MS1 is a compound (M1)X₂ capable of forming the perovskite compound, and is composed of, for example, a metal cation M1 and an anion X that is a counter anion of the metal cation M1. This metal cation M1 is the same as the above-described metal cation M1, and preferred examples thereof are the same as described above. The anion X is the same as the anion of the anionic atom or atomic group X. As the anion X, a halide ion or monovalent organic anion is preferable, and the halide ion is more preferable. Examples of the halide ion include a fluoride ion, a chloride ion, a bromide ion, an iodide ion, and the like, and the iodide ion is preferable. The monovalent organic anion is not particularly limited, and examples thereof include an acetic acid ion (CH₃COO⁻), a formic acid ion (HCOO⁻), NC⁻, NCS⁻, NCO⁻, HO⁻, NO₃⁻, and the like. Among these, the acetic acid ion and the formic acid ion are preferable.

Examples of the metal salt MS1 include PbX₂, SnX₂, GeX₂, CuX₂, MnX₂, FeX₂, and the like. Here, X represents a halide ion or a monovalent organic anion.

It is preferable that the metal salt MS2 is a compound that generates the metal cation M2, and examples thereof include an oxide, a halide, a hydroxide, a sulfide, a cyanide, an organic acid salt, or an inorganic acid salt (acetate, oxo acid salt, sulfate, carbonate, and the like), a hydrogen compound, a metal complex, and the like of a metal cation M2. Among these, as the metal salt MS2, the organic acid salt or the inorganic acid salt, the halide of the metal cation M2 are preferable, and the acetate and the halide of the metal cation M2 are more preferable.

The metal cation M2 of the metal salt MS2 is the same as the above-described metal cation M2, and preferred examples thereof are the same as described above. The anion X of the metal salt MS2 is not particularly limited, and examples thereof include anions which form the individual compounds, or the same anion as the anion X of the metal salt MS1. Among these, halide ions or the monovalent organic anions are preferable, and an iodide ion, and an acetic acid ion are more preferable.

Examples of the metal salt MS2 include (M2)X₄, and specific examples thereof include Pb(OAc)₄, PbX₄, Sn(OAc)₄, SnX₄, GeX₄, and the like. Here, X represents a halide ion or a monovalent organic anion (excluding an acetic acid ion).

In the metal salt composition, a combination of the metal cation M1 and the metal cation M2, and a ratio between the amounts thereof are the same as the combination and the ratio between the amounts which are described in the photosensitive layer 13, and a preferred combination and a preferred ratio between the amounts are the same as described above.

In the metal salt composition, content rates (concentrations) of the metal salt MS1 (metal cation M1) and the metal salt MS2 (metal cation M2) are not particularly limited as long as the ratio between the amounts is satisfied. For example, in the metal salt composition, the content rate of the metal salt MS1 is preferably 1×10⁻⁵ to 16 mol/L, and more preferably 0.1 to 5 mol/L. The content rate of the metal salt MS2 is preferably 1×10⁻⁶ to 16 mol/L, and more preferably 1×10⁻⁴ to 1 mol/L.

It is preferable that the salt AX is a compound capable of forming the perovskite compound represented by Formula (I). In the salt AX, A represents a cation capable of forming the perovskite-type crystal structure. A is the same as the cation of the elements of Group 1 in the periodic table or the cationic organic group A, and preferred examples thereof are the same as described above. X is an anion capable of forming the perovskite compound. X is the same as the anion of the anionic atom or atomic group, and preferred examples thereof are the same as described above.

In a preferred method, the amount of the salt AX used (a molar ratio between the salt AX and the metal salt MS1 in the metal salt composition) is appropriately adjusted in correspondence with the purpose and the like. For example, the molar ratio is preferably 1:1 to 1:10.

The salt AX is preferably used as an organic salt composition that includes the following organic solvent from the viewpoint of application properties. In this case, the concentration of the salt AX in the organic salt composition is not particularly limited, and is appropriately determined. For example, the concentration is preferably 1×10⁻⁵ to 16 mol/L, more preferably 1×10⁻⁴ to 10 mol/L, and still more preferably 0.1 to 5 mol/L.

As the organic solvent that is used in the metal salt composition and the organic salt composition, the following solvent or dispersion medium may be exemplified.

It is possible to prepare the metal salt composition and the organic salt composition by mixing respective components and, preferably, by heating the resultant mixture. Heating conditions will be described later.

In the method using the composition that contains the entirety of the compounds, a raw material composition, which contains the metal salts MS1 and MS2, the salt AX, and the organic solvent, is prepared. A ratio between the amounts of the metal salt MS1 and the metal salt MS2 which are contained in the raw material composition is the same as the ratio in the metal salt composition, and preferred examples thereof are the same as described above. In addition, a molar ratio between the metal salt MS1 and the salt AX is appropriately adjusted in correspondence with the purpose. For example, a molar ratio of 1:1 to 1:10 is preferable.

It is possible to prepare the raw material composition by mixing the metal salts MS1 and MS2, and the salt AX in a predetermined molar ratio and, preferably, by heating the resultant mixture.

Heating conditions are not particularly limited. A heating temperature is preferably 30°C to 200°C, more preferably 60°C to 150°C, and still more preferably 70°C to 150°C. Heating time is preferably 0.5 to 100 hours, and more preferably 1 to 3 hours.

Subsequently, the metal salt composition or the raw material composition, which is prepared, is brought into contact with a surface of a layer on which the photosensitive layer 13 is to be formed. Here, in the photoelectric conversion element 10, the layer on which the photosensitive layer 13 is to be formed is any one layer among the porous layer 12, the blocking layer 14, the electron transport layer 15, and the hole transport layer 16. According to this, it is possible to bring the metal salt MS1, the metal salt MS2, and the salt AX into contact with each other on the surface of the layer on which the photosensitive layer 13 is to be formed.

Examples of the method of bringing the metal salts and the like into contact with the surface include a wet-type method and a dry-type method, and there is no particular limitation thereto. In the invention, the wet-type method is preferable. More preferable examples of the method include a method of applying the metal salt composition and the like to the surface, and a method of immersing the surface in the metal salt composition and the like. In these methods, a contact temperature is preferably 5°C to 100°C. Immersion time is preferably 5 seconds to 24 hours, and more preferably 20 seconds to I hour. In a case of drying the metal salt composition and the like which are applied, with regard to the drying, drying with heat is preferable, and the drying is performed by heating the metal salt composition and the like typically at 20°C to 300°C, and preferably at 50°C to 170°C.

In a preferred method in which the metal salt composition and the salt AX are sequentially brought into contact with the surface, it is preferable that the metal salt composition and an organic composition are individually applied (including the immersion method), and these compositions are dried as necessary. Either the metal salt composition or the organic composition may be previously applied, but it is preferable that the metal salt composition is previously applied. Application conditions and drying conditions of the metal salt composition and the organic composition are the same as described above.

In addition, it is also possible to employ a dry-type method such as a vacuum vapor deposition by using a metal salt composition or an organic composition through which an organic solvent is removed instead of the application of the metal salt composition or the organic composition. For example, a method in which the metal salt composition and the organic composition are simultaneously or sequentially vapor-deposited can be exemplified.

In this manner, when the metal salt composition and the organic composition are sequentially brought into contact with the surface, the metal salts MS1 and MS2, and the salt AX come into contact with each other on the surface. According to this, the metal salt MS1 and the salt AX react with each other and thus the perovskite-type light absorbing agent is synthesized, and the metal cation M2 is drawn to the perovskite-type light absorbing agent. According to this, the photosensitive layer 13, which the perovskite-type light absorbing agent that contains the metal cation M2, is formed.

On the other hand, in the method using the raw material composition, the raw material composition is brought into contact with the surface. According to this, the metal salt MS1 and the salt AX react with each other on the surface, and the metal salt MS2 is drawn to the perovskite-type light absorbing agent. As a result, the photosensitive layer 13, which includes the perovskite-type light absorbing agent that contains the metal cation M2, is formed. Furthermore, in the raw material composition, in a case where the metal salt MS1 and the salt AX already react with each other, the perovskite-type light absorbing agent is provided on the surface.

In the method, a metal salt composition or an organic composition, which does not contain the salt AX, may be applied.

In this manner, the perovskite compound is formed on the surface of the porous layer 12, the blocking layer 14, the electron transport layer 15, or the hole transport layer 16 as the photosensitive layer 13.

The hole transport layer 3 or the electron transport layer 4 is preferably formed on the photosensitive layer 13 that is prepared as described above.

The hole transport layer 3 can be formed by applying and drying a hole transporting material solution that contains a hole transporting material. In the hole transporting material solution, the concentration of the hole transporting material is preferably 0.1 to 1.0 M (mol/L) when considering that application properties are excellent, and in a case where the porous layer 12 is provided, the hole transporting material is capable of easily intruding into pores in the porous layer 12.

The electron transport layer 4 can be formed by applying and drying an electron transporting material solution that contains an electron transporting material.

After the hole transport layer 3 or the electron transport layer 4 is formed, the second electrode 2 is formed, thereby manufacturing the photoelectric conversion element.

The film thicknesses of the respective layers can be adjusted by appropriately changing the concentrations of respective dispersion liquids or solutions and the number of times of application. For example, in a case where the photosensitive layers 13B and 13C having a large film thickness are provided, a light absorbing agent solution may be applied and dried a plurality of times.

The respective dispersion liquids and solutions described above may respectively contain additives such as a dispersion auxiliary agent and a surfactant as necessary.

Examples of the solvent or dispersion medium that is used in the method of manufacturing the photoelectric conversion element include a solvent described in JP2001-291534A, but the solvent or dispersion medium is not particularly limited thereto. In the invention, an organic solvent is preferable, and an alcohol solvent, an amide solvent, a nitrile solvent, a hydrocarbon solvent, a lactone solvent, a halogen solvent, a sulfide solvent, and a mixed solvent of two or more kinds thereof are preferable. As the mixed solvent, a mixed solvent of the alcohol solvent and a solvent selected from the amide solvent, the nitrile solvent, and the hydrocarbon solvent is preferable. Specifically, methanol, ethanol, isopropanol, γ-butyrolactone, n-propylsulfide, chlorobenzene, acetonitrile, N,N-dimethylformamide (DMF), dimethylacetamide, and a mixed solvent thereof are preferable.

A method of applying the solutions or dispersants which form the respective layers is not particularly limited, and it is possible to use a known application method such as spin coating, extrusion die coating, blade coating, bar coating, screen printing, stencil printing, roll coating, curtain coating, spray coating, dip coating, an inkjet printing method, and an immersion method. Among these, spin coating, screen printing, and the like are preferable.

The photoelectric conversion element of the invention may be subjected to an efficiency stabilizing treatment such as annealing, light soaking, and being left as is in an oxygen atmosphere as necessary.

The photoelectric conversion element prepared as described above can be used as a solar cell after connecting the external circuit 6 to the first electrode 1 (transparent electrode 11b) and the second electrode 2.

### Examples

Hereinafter, the invention will be described in more detail on the basis of examples, but the invention is not limited to the following examples.

### Example 1

### (Manufacturing of Photoelectric Conversion Element (Sample No. 101))

The photoelectric conversion element 10A illustrated in Fig. 1 was prepared in the following procedure. Furthermore, a case where the film thickness of the photosensitive layer 13 is large corresponds to the photoelectric conversion element 10B illustrated in Fig. 2.

### <Preparation of Conductive Support 11>

A fluorine-doped SnO₂ conductive film (the transparent electrode 11b, film thickness: 300 nm) was formed on a glass substrate (the support 11a, thickness: 2 mm), thereby preparing the conductive support 11.

### <Preparation of Solution for Blocking Layer>

An isopropanol solution, which contains 15% by mass of titanium diisopropoxide bis(acetylacetonate) (manufactured by Sigma-Aldrich Co. LLC) was diluted with 1-butanol, thereby preparing 0.02 M (mol/L) solution for a blocking layer.

### <Formation of Blocking Layer 14>

The blocking layer 14 formed from titanium oxide (film thickness: 50 nm) was formed on the SnO₂ conductive film of the conductive support 11 by using the prepared 0.02 M solution for the blocking layer at 450°C in accordance with a spray pyrolysis method.

### <Preparation of Titanium Oxide Paste>

Ethyl cellulose, lauric acid, and terpineol were added to an ethanol dispersion liquid of titanium oxide (anatase, an average particle size: 20 nm), thereby preparing titanium oxide paste.

### <Formation of Porous Layer 12>

The prepared titanium oxide paste was applied onto the blocking layer 14 with a screen printing method, and was baked. Application and baking of the titanium oxide paste were respectively performed two times. With regard to a baking temperature, first baking was performed at 130°C, and second baking was performed at 500°C for 1 hour. A baked body of the titanium oxide, which was obtained, was immersed in 40 mM TiCl₄ aqueous solution, and was heated at 60°C for 1 hour, and heating was continuously performed at 500°C for 30 minutes, thereby forming the porous layer 12 (film thickness: 250 nm) formed from TiO₂.

### <Preparation of Metal Salt Composition and Organic Salt Composition>

PbI₂ as the metal salt MS1 and Pb(OAc)₄ as the metal salt MS2 were put into 1.5 mL of DMF in a ratio of 99.8:0.2 ([M1]/[M2])=499) in terms of a molar ratio (PbI₂:Pb(OAc)₄), and was stirred and mixed at 60°C for 12 hours. Then, the resultant mixed solution, which was obtained, was filtered with a polytetrafluoroethylene (PTFE) syringe filter, thereby preparing a metal salt composition in which a total concentration of PbI₂ and Pb(OAc)₄ is 40% by mass (1.2 mol/L).

Here, the amount of the metal cation M2 contained and a molar ratio ([M1]/[M2]) between the amount of the metal cation M2 contained in the metal salt composition, can be obtained as follows.

It is possible to identify element species of metal cations contained in the metal salt composition, and a composition ratio thereof through ICP analysis on the metal salt composition. In addition, in a case where the metal salt composition or the metal salt composition is a liquid, it is possible to measure signal intensities of peaks corresponding to the metal cation M1 and the metal cation M2 through XAFS analysis for a test film that is formed with the metal salt composition. It is possible to obtain a molar ratio ([M1]/[M2]) of the amounts of the metal cations by plotting these values with respect to a calibration curve which is created in advance by using the metal cation M1 alone, the metal cation M2 alone, and a sample obtained by mixing the metal cation M1 and the metal cation M2 in a specific ratio and in which the horizontal axis represents a molar ratio ([M1]/[M2]) and the vertical axis represents the signal intensity of an M1 material.

In addition, a 40% methanol solution (27.86 mL) of methyl amine, and an aqueous solution of 57% by mass of hydrogen iodide (hydroiodic acid: 30 mL) were stirred in a flask at 0°C for 2 hours, and was concentrated to obtain coarse CH₃NH₃I. The obtained coarse CH₃NH₃I was dissolved in ethanol and was recrystallized with diethylether. A crystal that was obtained was filtered and collected, and was dried under reduced pressure at 60°C for 5 hours, thereby obtaining purified CH₃NH₃I. The purified CH₃NH₃I, which was obtained, was dissolved in isopropanol and was filtered with a PTFE syringe filter, thereby preparing an organic salt composition that contains CH₃NH₃I in a concentration of 1% by mass (6×10⁻³ mol/L).

### <Formation of Photosensitive Layer 13A>

The metal salt composition was applied onto the porous layer 12 formed on the conductive support 11 with a spin coating method (for 60 seconds at 2000 rpm, an application temperature: 50°C), and the applied metal salt composition was dried by using a hot plate at 100°C for 30 minutes. The resultant metal salt composition was immersed in an organic salt composition for 10 seconds (an immersion temperature: room temperature (25°C)), and was dried by using a hot plate at 100°C for 60 minutes.

In this manner, the photosensitive layer 13A (film thickness: 300 nm (including the film thickness 250 nm of the porous layer 12)), which is formed from the perovskite-type light absorbing agent composed of CH₃NH₃PbI₃ was prepared. The photosensitive layer 13A contained the metal cation M2.

In this manner, the first electrode 1A was prepared.

### <Preparation of Hole Transporting Material Solution>

spiro-MeOTAD (180 mg) as the hole transporting material was dissolved in chlorobenzene (1 mL). 37.5 of an acetonitrile solution obtained by dissolving lithium-bis (trifluoromethanesulfonyl) imide (170 mg) in acetonitrile (1 mL) and t-butyl pyridine (TBP, 17.5 µL) were additionally mixed to the chlorobenzene solution, thereby preparing a solution for the hole transport layer.

### <Formation of Hole Transport Layer 3A>

Subsequently, the solution for the hole transport layer, which was prepared, was applied onto the photosensitive layer 13 of the first electrode 1 by using a spin coating method, and the hole transporting material solution, which was applied, was dried to form the hole transport layer 3A (film thickness: 100 nm) having a solid shape.

### <Preparation of Second Electrode 2>

Gold was vapor-deposited onto the hole transport layer 3A with a vapor deposition method, thereby preparing the second electrode 2 (film thickness: 100 nm).

In this manner, the photoelectric conversion element 10A (Sample No. 101) was manufactured.

Respective film thicknesses were measured through observation with a SEM according to the above-described method.

### (Manufacturing of Photoelectric Conversion Elements (Sample Nos. 102 to 108))

Photoelectric conversion elements (Sample Nos. 102 to 106) were respectively manufactured in the same manner as in the manufacturing of the photoelectric conversion element (Sample No. 101) except that SnI₄ was used instead of Pb(OAc)₄ as the metal salt MS2, and the ratio [M1]/[M2] of the amounts was changed to a value illustrated in Table 1 in comparison to the manufacturing of the photoelectric conversion element (Sample No. 101).

In addition, photoelectric conversion elements (Sample Nos. 107 and 108) were respectively manufactured in the same manner as in the manufacturing of the photoelectric conversion element (Sample No. 101) except that the ratio [M1]/[M2] of the amounts was changed to a value illustrated in Table 1 in comparison to the manufacturing of the photoelectric conversion element (Sample No. 101).

In the respective photoelectric conversion elements of the sample numbers, the photosensitive layer 13A, which is formed from the perovskite-type light absorbing agent composed of CH₃NH₃PbI₃, contained the metal cation M2.

### (Manufacturing of Photoelectric Conversion Element (Sample No. 109))

A photoelectric conversion element (Sample No. 109) was manufactured in the same manner as in the manufacturing of the photoelectric conversion element (Sample No. 101) except that a mixture (PbI₂:SnI₂=70:30 in a molar ratio) of PbI₂ and SnI₂ was used instead of PbI₂ in the same amount as that of PbI₂ as the metal salt MS1 in comparison to the manufacturing of the photoelectric conversion element (Sample No. 101).

The photosensitive layer 13A, which is formed from the perovskite-type light absorbing agent composed of CH₃NH₃PbI₃, contained the metal cation M2.

### (Manufacturing of Photoelectric Conversion Elements (Sample Nos. 110 to 114))

Photoelectric conversion elements (Sample Nos. 110 to 114) were respectively prepared in the same manner as in the manufacturing of the photoelectric conversion element (Sample No. 101) except that the (M2)I₃ or (M2)I was used instead of Pb(OAc)₄ as the metal salt MS2 in comparison to the manufacturing of the photoelectric conversion element (Sample No. 101).

Here, M2 in the metal salt represents the metal cation M2 illustrated in Table 1.

### (Manufacturing of Photoelectric Conversion Element (Sample No. 115))

A photoelectric conversion element (Sample No. 115) was prepared in the same manner as in the manufacturing of the photoelectric conversion element (Sample No. 102) except that CH₃NH₃I as the salt AX was changed to HC(=NH)NH₃I in comparison to the manufacturing of the photoelectric conversion element (Sample No. 102).

The perovskite-type light absorbing agent that forms the photosensitive layer 13A in the photoelectric conversion element is illustrated in Table 1.

### (Manufacturing of Photoelectric Conversion Element (Sample No c01))

A photoelectric conversion element (Sample No. c01) was prepared in the same manner as in the manufacturing of the photoelectric conversion element (Sample No. 101) except that the photosensitive layer 13A was formed as follows in comparison to the manufacturing of the photoelectric conversion element (Sample No. 101).

### <Preparation of Light Absorbing Agent Solution and Formation of Photosensitive Layer 13A>

Purified CH₃NH₃I prepared in the manufacturing of the photoelectric conversion element (Sample No.101), and PbI₂ were stirred and mixed in a molar ratio of 3:1 in DMF at 60°C for 12 hours, and the resultant mixture was filtered with a PTFE syringe filter, thereby preparing 40% by mass of light absorbing agent solution.

The light absorbing agent solution, which was prepared, was applied onto the porous layer 12 formed on the conductive support 11 with a spin coating method (for 60 seconds at 2000 rpm), and the applied light absorbing agent solution was dried by using a hot plate at 100°C and for 60 minutes, thereby providing the photosensitive layer 13A (film thickness: 300 nm (including the film thickness of 250 nm of the porous layer 12)) formed from the perovskite-type light absorbing agent composed of CH₃NH₃PbI₃.

### (Manufacturing of Photoelectric Conversion Element (Sample No. c02))

A photoelectric conversion element (Sample No. c02) was manufactured in the same manner as in the manufacturing of the photoelectric conversion element (Sample No. c01) except that a mixture (PbI₂:SnI₂=70:30 in a molar ratio) of PbI₂ and SnI₂ was used instead of PbI₂ in the same amount as that of PbI₂ in comparison to the manufacturing of the photoelectric conversion element (Sample No. c01).

### (Manufacturing of Photoelectric Conversion Element (Sample No. c03))

A photoelectric conversion element (Sample No. c03) was manufactured in the same manner as in the manufacturing of the photoelectric conversion element (Sample No. c01) except that CH₃NH₃I as the salt AX was changed to HC(=NH)NH₃I in comparison to the manufacturing of the photoelectric conversion element (Sample No. c01).

The perovskite-type light absorbing agent, which forms the photosensitive layer 13A in the photoelectric conversion element, is illustrated in Table 1.

### <Measurement of Amount of Metal Cations M1 and M2>

With respect to the photoelectric conversion element (Sample No. 105) that was obtained, the amounts of the metal cations M1 and M2 contained in the photosensitive layer 13A formed from the perovskite-type light absorbing agent was measured to calculate the molar ratio ([M1]/[M2]) of the amounts. A measurement method and a calculation method correspond to the ICP analysis and XAFS. As a result, it could be seen that the amounts of the metal cations M1 and M2, and the ratio of the amounts were approximately the same as those in the metal salt composition that was used.

### <Evaluation of Short-Circuit Current Value>

With respect to the respective photoelectric conversion elements of the sample numbers, a battery characteristic test was performed to measure a short-circuit current value (JSC) thereof. The battery characteristic test was performed through irradiation of pseudo-solar light of 1000 W/m² from a xenon lamp through an AM 1.5 filter by using a solar simulator "WXS-85H" (manufactured by Wacom). Current-voltage characteristics were measured by using an I-V tester.

Evaluation was performed by a relative value with respect to a short-circuit current value (JSC^{c01}) of the photoelectric conversion element of Sample No. c01 (short-circuit current value of the respective photoelectric conversion elements of the sample numbers (JSC)/(JSC^{c01})) in accordance with the following evaluation criteria. In the evaluation criteria of the short-circuit current value, a passing level in this test is Evaluation "D" or higher, and preferably Evaluation "C" or higher. Results are illustrated in the following Table 1.

### - Evaluation Criteria of Short-Circuit Current Value -

With regard to the relative value with respect to the short-circuit current value (JSC^{c01}) of the photoelectric conversion element of Sample No. c01, the evaluation criteria are as follows.
A: 1.04 or greater
B: Equal to or greater than 1.03 and less than 1.04
C: Equal to or greater than 1.02 and less than 1.03
D: Equal to or greater than 1.01 and less than 1.02
E: Less than 1.01

### <Evaluation of Performance Variation>

Twelve specimens of photoelectric conversion elements were manufactured for each of the sample numbers in the same manner as in the methods of manufacturing the photoelectric conversion elements. Photoelectric conversion efficiency (η/%) was obtained for each sample number by the battery characteristic test, and variation thereof was evaluated.

An average value (ηₐᵥ) of the photoelectric conversion efficiency was obtained with respect to eight specimens excluding two specimens from a high photoelectric conversion efficiency side and two specimens from a low photoelectric conversion efficiency side among the twelve specimens of photoelectric conversion elements. The average value (ηₐᵥ) of the photoelectric conversion efficiency was set to 1 (reference), and relative values (Aᵣₑ) of the photoelectric conversion efficiency of the twelve specimens with respect to the average value (ηₐᵥ) were calculated. Ranges, which include the maximum value (relative value in which an absolute value of a difference from the reference becomes the maximum) among the relative values (Aᵣₑ) of the photoelectric conversion efficiency which were obtained as described above, were classified in accordance with the following criteria to evaluate the "variation" of the photoelectric conversion efficiency.

In the evaluation criteria of the variation in the photoelectric conversion efficiency, a passing level in this test is Evaluation "B" or higher, and preferably Evaluation "A" or higher. Results are illustrated in the following Table 1.

### - Evaluation Criteria of Variation in Photoelectric Conversion Efficiency -

With regard to the maximum value among relative values (Aᵣₑ) of photoelectric conversion efficiency, criteria are as follows.
A: Maximum value is in a range of 0.85 to 1.15
B: Maximum value is in a range of equal to or greater than 0.70 and less than 0.85, or in a range of greater than 1.15 and less than 1.30
C: Maximum value is in a range of less than 0.70, or in a range of 1.30 or greater

It was confirmed that the photoelectric conversion efficiency, which was measured in the performance variation evaluation, of the photoelectric conversion elements (Sample Nos. 101 to 115), has a level at which a solar cell can sufficiently function.

### <Film Surface Defect Evaluation>

A porous layer corresponding to the porous layer 12 was formed on a substrate (25 mm×25 mm) in the same manner as in the Sample No. 101. A photosensitive layer coated film corresponding to each photosensitive layer 13A was formed on the porous layer by using the metal salt composition and the organic salt composition, or the light absorbing agent solution in the same manner as in the methods of manufacturing the photoelectric conversion elements (Sample Nos. 102 to 107, 110 to 115, c01, and c03). In this manner, fifteen sheets of photosensitive layer coated films were prepared for each of the sample numbers. With respect to the respective photosensitive layer coated films for each of the sample numbers, the photosensitive layer coated films were observed to count the number of photosensitive layer coated films for which a film surface defect was confirmed. The film surface defect was defined as occurrence of any one of crawling, application missing, and an aggregate in the photosensitive layer coated film. From the number of the photosensitive layer coated films, application properties (film surface defect) were evaluated on the following evaluation criteria. In the film surface defect evaluation, Evaluation "A" and Evaluation "B" are preferable.

In this test, whether or not crawling or application missing occurs was determined as follows. With respect to a range of the central portion of 20 mm×20 mm in a substrate of 25 mm square, an application surface of the photosensitive layer coated film was observed by using a microscope (magnification:×100 to ×500). In a case where a site, at which the photosensitive layer coated film was not formed, was confirmed at least in a range having a side of 0.5 mm or greater, this case was regarded as occurrence of a defect due to crawling or application missing.

In this test, whether or not the aggregate exists was determined as follows. A direction perpendicular to a substrate was set as a Z-axis direction, and in the substrate, directions of both substrate edges, which vertically intersect each other, were respectively set as an X-axis direction and a Y-axis direction. In addition, the center of the substrate was set as a central point C. The central point C is an intersection between a straight-line that passes through the central point (position at 12.5 mm) of the substrate in the X-axis direction and is parallel to the Y-axis direction, and a straight-line that passes through the central point (position at 12.5 mm) of the substrate and is parallel to the X-axis direction.

With respect to the central portion of the substrate with the central point C set as the center, when observing a rectangular range of 1.2 mm (in the X-axis direction)×0.9 mm (in the Y-axis direction) with resolution of 5 µm in each of the X-axis direction and the Y-axis direction to measure Rp (maximum height) in the Z-axis direction by using a white light interferometer (Wyko, manufactured by Veeco Instruments Inc.), in a case where a portion (referred to as "aggregate") of which Rp is 2 µm or greater exists, determination was made as existence of film surface defect due to an aggregate.

### - Film Surface Defect Evaluation Criteria -

A: Case where the number of photosensitive layer coated films, in which the film surface defect is confirmed, is less than two sheets
B: Case where the number of photosensitive layer coated films, in which the film surface defect is confirmed, is equal to or greater than two sheets and less than four sheets
C: Case where the number of photosensitive layer coated films, in which the film surface defect is confirmed, is four sheets or greater

**[Table 1]**

| Sample No. | Perovskite-type light absorbing agent | Metal cation | | | Short-circuit current value | Performance variation | Film surface defect | Remarks |
|---|---|---|---|---|---|---|---|---|
| | | M1 | M2 | [MI]/[M2] | | | | |
| c01 | CH₃NH₃PbI₃ | Pb²⁺ | - | - | E | C | C | Comparative Example |
| 101 | CH₃NH₃PbI₃ | Pb²⁺ | Pb⁴⁺ | 499 | C | A | - | Present invention |
| 102 | CH₃NH₃PbI₃ | Pb²⁺ | Sn⁴⁺ | 499 | B | A | A | Present invention |
| 103 | CH₃NH₃PbI₃ | Pb²⁺ | Sn⁴⁺ | 19 | B | A | A | Present invention |
| 104 | CH₃NH₃PbI₃ | Pb²⁺ | Sn⁴⁺ | 49 | A | A | A | Present invention |
| 105 | CH₃NH₃PbI₃ | Pb²⁺ | Sn⁴⁺ | 99 | A | A | A | Present invention |
| 106 | CH₃NH₃PbI₃ | Pb²⁺ | Sn⁴⁺ | 199 | A | A | A | Present invention |
| 107 | CH₃NH₃PbI₃ | Pb²⁺ | Pb⁴⁺ | 999 | D | B | B | Present invention |
| 108 | CH₃NH₃PbI₃ | Pb²⁺ | Pb⁴⁺ | 9 | D | A | - | Present invention |
| c02 | CH₃NH₃PbI₃ | Pb²⁺/Sn²⁺ = 70/30 | - | - | - E | C | - | Comparative Example |
| 109 | CH₃NH₃PbI₃ | Pb²⁺/Sn²+ = 70/30 | Pb⁴⁺ | 499 | C | A | - | Present invention |
| c03 | HC(=NH)NH₃PbI₃ | Pb²⁺ | - | - | E | C | C | Comparative Example |
| 110 | CH₃NH₃PbI₃ | Pb²⁺ | Bi³⁺ | 499 | C | A | A | Present invention |
| 111 | CH₃NH₃PbI₃ | Pb²⁺ | Sm³⁺ | 499 | C | A | A | Present invention |
| 112 | CH₃NH₃PbI₃ | Pb²⁺ | Ag⁺ | 499 | D | A | A | Present invention |
| 113 | CH₃NH₃PbI₃ | Pb²⁺ | Cu⁺ | 499 | D | A | A | Present invention |
| 114 | CH₃NH₃PbI₃ | Pb²⁺ | Al³⁺ | 499 | C | A | A | Present invention |
| 115 | HC(=NH)NH₃PbI₃ | Pb²⁺ | Sn⁴⁺ | 499 | B | A | A | Present invention |

From results in Table 1, it can be understood as follows.

Even in the photoelectric conversion elements using the perovskite compound as the light absorbing agent, in a case where the metal cation M1 as the central ion of the perovskite-type crystal structure, and the metal cation M2, of which a valence is different from a valence of the metal cation M1, of a metal atom other than elements of Group 1 in the periodic table are contained in the photosensitive layer formed from the perovskite-type light absorbing agent (Sample Nos. 101 to 115), the short-circuit current value increases, and it is possible to expect an improvement in the photoelectric conversion efficiency. In addition, even in a case where a plurality of the photoelectric conversion elements are manufactured by the same manufacturing method, the performance variation in the photoelectric conversion elements is reduced.

In a case where the valence of the metal cation M2 is greater than the valence of the metal cation M1, and in a case where the amount of the metal cation M2 contained is less than the amount of the metal cation M1 contained, it was confirmed that the short-circuit current value improving effect and the performance variation reducing effect are relatively enhanced.

In a case where the metal cation M1 is a divalent lead cation or a divalent tin cation, or in a case where the metal cation M2 is a tetravalent lead cation or a tetravalent tin cation, it was confirmed that the short-circuit current value improving effect and the performance variation reducing effect are further enhanced. Particularly, in a case where the metal cation M1 is the divalent lead cation, and the metal cation M2 is the tetravalent tin cation, the short-circuit current value further increased while maintaining excellent performance variation reducing effect.

In a case where the ratio of the amount of the metal cation M1 contained to the amount of the metal cation M2 contained is 19 to 499 in terms of a molar ratio ([M1]/[M2]), and is preferably 49 to 199, the short-circuit current value improving effect was high, and the performance variation reduction effect was also excellent.

In addition, it was confirmed that the photoelectric conversion elements of the invention include the uniform photosensitive layer 13A in which the film surface defect is less.

In contrast, with regard to the photoelectric conversion element using the perovskite compound as the light absorbing agent, in a case where the metal cation M1 as the central ion of the perovskite-type crystal structure, and the metal cation M2, of which a valence is different from a valence of the metal cation M1, of a metal atom other than elements of Group 1 in the periodic table are not contained in the photosensitive layer formed from the perovskite-type light absorbing agent (Sample Nos. c01 to c03), in the entirety of the photoelectric conversion elements, the short-circuit current value was small, and the performance variation in the photoelectric conversion elements was great.

### Example 2

### (Manufacturing Photoelectric Conversion Element (Sample No. 201))

The photoelectric conversion element 10C illustrated in Fig. 3 was manufactured in the following procedure.

The photoelectric conversion element 10C (Sample No. 201) of the invention was manufactured in the same manner as in the manufacturing of the photoelectric conversion element (Sample No. 105) except that the porous layer 12 was not provided, the photosensitive layer 13C was provided on the blocking layer 14, and the film thickness of the photosensitive layer 13C and the hole transport layer 3B was set to the following film thickness in comparison to the manufacturing of the photoelectric conversion element (Sample No. 105).

In the photoelectric conversion element 10C, the film thickness of the photosensitive layer 13C was 250 nm, and the film thickness of the hole transport layer 3B was 100 nm.

### (Manufacturing Photoelectric Conversion Element (Sample No. 202))

A photoelectric conversion element (refer to the photoelectric conversion element 10F illustrated in Fig. 6), which does not include the hole transport layer, was manufactured in the following procedure.

The photoelectric conversion element (Sample No. 202) of the invention was manufactured in the same manner as in the manufacturing of the photoelectric conversion element (Sample No. 105) except that the hole transport layer 3A was not provided, and the second electrode 2 was provided on the first electrode in comparison to the manufacturing of the photoelectric conversion element (Sample No. 105).

With respect to the respective photoelectric conversion elements which were manufactured, the evaluation of short-circuit current value and the performance variation evaluation were performed in the same manner as in Example 1. As a result, the entirety of the photoelectric conversion elements exhibited the same excellent effects as in the photoelectric conversion element (Sample No. 105) of Example 1.

The invention has been described in combination with embodiments thereof. However, it is not intended to limit the invention in any detailed part of the description unless particularly specified, and it should be understood that the invention is supposed to be widely interpreted within the spirit and the scope of the invention which are described in the appended claims.

Priority is claimed on Japanese Patent Application No. 2015-128511, filed June 26, 2015, the content of which is incorporated herein by reference.

### Explanation of References

1A to 1F: first electrode
11: conductive support
11a: support
11b: transparent electrode
12: porous layer
13A to 13C: photosensitive layer
14: blocking layer
2: second electrode
3A, 3B, 16: hole transport layer
4, 15: electron transport layer
6: external circuit (lead)
10A to 10F: photoelectric conversion element
100A to 100F: system using solar cell
M: electric motor

## Claims

1. A photoelectric conversion element, comprising:
a first electrode that includes a photosensitive layer containing a perovskite-type light absorbing agent on a conductive support; and
a second electrode that is opposite to the first electrode,
wherein the perovskite-type light absorbing agent includes a metal cation M1 as a central ion of a perovskite-type crystal structure of the perovskite-type light absorbing agent, and a metal cation M2, of which a valence is different from a valence of the metal cation M1, of a metal atom other than elements of Group 1 in the periodic table.

2. The photoelectric conversion element according to claim 1,
wherein the perovskite-type light absorbing agent is formed by bringing a metal salt MS1 in which the metal cation M1 is set as a cation, a metal salt MS2 in which the metal cation M2 is set as a cation, and a salt AX in which a cation other than the central ion of the perovskite-type crystal structure is set as a cation into contact with each other on a surface on which the photosensitive layer is formed.

3. The photoelectric conversion element according to claim 1 or 2,
wherein a valence of the metal cation M2 is greater than a valence of the metal cation M1, and
the amount of the metal cation M2 contained is smaller than the amount of the metal cation M1 contained.

4. The photoelectric conversion element according to any one of claims 1 to 3,
wherein a ratio of the amount of the metal cation M1 contained to the amount of the metal cation M2 contained is 19 to 499 in terms of a molar ratio.

5. The photoelectric conversion element according to any one of claims 1 to 4,
wherein a ratio of the amount of the metal cation M1 contained to the amount of the metal cation M2 contained is 49 to 199 in terms of a molar ratio.

6. The photoelectric conversion element according to any one of claims 1 to 5,
wherein the metal cation M1 is at least one kind selected from the group consisting of a divalent lead cation and a divalent tin cation.

7. The photoelectric conversion element according to any one of claims 1 to 6,
wherein the metal cation M2 is at least one kind selected from the group consisting of a tetravalent lead cation and a tetravalent tin cation.

8. The photoelectric conversion element according to any one of claims 1 to 7,
wherein the metal cation M1 is a divalent lead cation, and the metal cation M2 is a tetravalent tin cation.

9. The photoelectric conversion element according to any one of claims 1 to 8,
wherein the perovskite-type light absorbing agent includes a compound having a perovskite-type crystal structure that includes a cation of elements of Group 1 in the periodic table or a cationic organic group A, a metal cation of the metal atom M1 other than elements of Group 1 in the periodic table, and an anion of an anionic atom or atomic group X.

10. The photoelectric conversion element according to any one of claims 1 to 9, further comprising:
a hole transport layer that is provided between the first electrode and the second electrode.

11. The photoelectric conversion element according to any one of claims 1 to 10, further comprising:
a porous layer that is provided between the conductive support and the photosensitive layer.

12. A solar cell that uses the photoelectric conversion element according to any one of claims 1 to 11.

13. A metal salt composition that is for use to form a perovskite-type light absorbing agent that includes a metal cation M1 as a central ion of a perovskite-type crystal structure, and a metal cation M2, of which a valence is different from a valence of the metal cation M1, of a metal atom other than elements of Group 1 in the periodic table, the metal salt composition containing:
a metal salt MS1 in which the metal cation M1 is set as a cation, a metal salt MS2 in which the metal cation M2 is set as a cation, and an organic solvent.

14. The metal salt composition according to claim 13,
wherein the metal salts MS1 and MS2 include a halide ion or a monovalent organic anion as an anion.

15. A method of manufacturing the photoelectric conversion element according to any one of claims 1 to 11, the method comprising:
bringing a metal salt MS1 in which a metal cation M1 as a central ion of a perovskite-type crystal structure is set as a cation, a metal salt MS2 in which a metal cation M2, of which a valence is different from a valence of the metal cation M1, of a metal atom other than elements of Group 1 in the periodic table is set as a cation, and a salt AX in which a cation other than the central ion of the perovskite-type crystal structure is set as a cation into contact with each other on a surface of a layer on which a photosensitive layer is to be formed so as to form a perovskite-type light absorbing agent on the surface.

16. The method of manufacturing the photoelectric conversion element according to claim 15,
wherein a metal salt composition, which contains the metal salt MS1, the metal salt MS2, and an organic solvent, is brought into contact with the surface, and the salt AX is subsequently brought into contact with the surface.
